# EUROPEAN PATENT SPECIFICATION

(11) **EP 4 272 244 B1**
(45) Date of publication and mention of the grant of the patent: **10.07.2024**
(21) Application number: 22713608.2
(22) Date of filing: 08.03.2022
(51) Int. Cl.: H01L 21/67

(54) **PROCESSING LINE FOR PROCESSING A SUBSTRATE USED FOR THE MANUFACTURE OF A SOLAR CELL AND METHOD OF OPERATING A PROCESSING LINE FOR PROCESSING A SUBSTRATE USED FOR THE MANUFACTURE OF A SOLAR CELL**
VERARBEITUNGSLINIE ZUR VERARBEITUNG EINES SUBSTRATS ZUR HERSTELLUNG EINER SOLARZELLE UND VERFAHREN ZUM BETRIEB EINER VERARBEITUNGSLINIE ZUR HERSTELLUNG EINES SUBSTRATS
LIGNE DE TRAITEMENT POUR TRAITER UN SUBSTRAT UTILISÉ POUR LA FABRICATION D'UNE CELLULE SOLAIRE ET PROCÉDÉ DE FONCTIONNEMENT D'UNE LIGNE DE TRAITEMENT POUR TRAITER UN SUBSTRAT UTILISÉ POUR LA FABRICATION D'UNE CELLULE SOLAIRE

(43) Date of publication of application: 08.11.2023
(73) Proprietor: Applied Materials Italia S.R.L., 31048 San Biagio di Callalta (TV) (IT)
(72) Inventor: COLLA, Davide, 31100 Treviso (IT)
(74) Representative: Zimmermann & Partner Patentanwälte mbB
(86) International application number: PCT/EP2022/055883
(87) International publication number: WO 2023/169658

(56) References cited:
- WO-A1-2012/133441
- WO-A1-2015/057959
- US-A1- 2005 085 177
- US-A1- 2011 262 252
- US-A1- 2012 199 065
- US-B1- 6 318 948

## Description

### FIELD

Embodiments described herein relate to a processing line for processing a substrate used for the manufacture of a solar cell. The processing line may include several stations, including one or more printing stations for printing a conductive pattern on the substrate. The substrate may be transported along the processing line, from one station to the next, for manufacturing a solar cell, more specifically for printing patterns of fingers and busbars on the front and back side of the substrate to manufacture a solar cell. Embodiments described herein also relate to a method of operating a processing line for processing a substrate used for the manufacture of a solar cell.

### BACKGROUND

Solar cells, or photovoltaic cells, are devices that convert sunlight into electrical power. A solar cell includes a substrate or wafer, for example a silicon wafer. Patterns of conductive material can be formed on the substrate. For example, a solar cell can include a set of fingers that are formed on the substrate. The fingers can be a plurality of parallel lines made of a conductive material, such as silver. A solar cell can include a set of busbars that are also formed on the substrate. The busbars can likewise be a plurality of parallel lines made of a conductive material such as silver.

For manufacturing a solar cell, a processing line including several stations may be provided. A substrate may be transported along the processing line for processing the substrate in the respective stations. At the end of the processing line, a solar cell is obtained. The processing line may include several printers, each printer being responsible for printing a respective pattern on the substrate. In addition, a processing line may include other types of stations, for example one or more ovens for curing the pattern(s) deposited on the substrate, one or more inspection stations for inspecting the substrate, and the like.

When the stations of the processing line have been in use for a certain amount of time, it may be advantageous to perform maintenance, repair or inspection of some of the apparatuses in the stations, for example to replace parts that have broken down or are worn out, to replenish a supply of printing material in the printers, to inspect whether the apparatuses are still working properly, and the like. Human operators may be used to perform such tasks. However, often it is only possible for human operators to access a station of the processing line when the station in question is temporarily shut down, leading to an undesirable downtime whenever the aforementioned maintenance, repair or inspection tasks have to be performed.

WO 2015/057959 A1 describes a processing apparatus. A front end generally includes load port modules. The load port modules may be configured as 200 mm wafer/substrate interfaces, 450 mm wafer/substrate interfaces or any other suitable substrate interfaces such as for example larger or smaller semiconductor wafers/substrates, flat panels for flat panel displays, solar panels, reticles or any other suitable object. A vacuum back end generally includes a transport chamber, one or more processing station(s) and any suitable transfer unit module or transport module that includes one or more transfer robots. The transfer unit module may include a telescoping linear traversing mechanism that may substantially span from adjacent one lateral side of the transport chamber to adjacent the other lateral side of the transport chamber. For example, the linear traversing mechanism may be mounted to a linear track.

US 2011/262252 A1 describes a substrate processing system and substrate transferring method, which is capable of transferring a substrate bi-directionally through the use of substrate transferring device provided between two rows of processing chambers arranged linearly, thereby improving the substrate-transferring efficiency, the substrate processing system comprising a transfer chamber having at least one bi-directional substrate transferring device for bi-directionally transferring a substrate; and a plurality of processing chambers for applying a semiconductor-manufacturing process to the substrate, wherein the plurality of processing chambers are linearly arranged along two rows confronting each other, and the transfer chamber is interposed between the two rows of the processing chambers, wherein the at least one bi-directional substrate transferring device comprises a moving unit provided inside the transfer chamber, and horizontally moved by a linear motor; and a bi-directional substrate transferring unit provided in the moving unit, the bi-directional substrate transferring unit for transferring the substrate to the processing chamber through a bi-directional sliding movement.

US 2005/085177 A1 describes that, in a working method of performing work on a workpiece, a plurality of work chambers corresponding to work steps for the workpiece are consecutively arrayed, and a cleanliness with respect to dust particles is independently controlled in each of the work chambers. The workpiece is transferred to the respective work chambers, and working is performed in each of the work chambers in which a cleanliness is maintained below a predetermined cleanliness corresponding to the type of work on the workpiece.

In light of the above, there is a need for improved processing lines for processing a substrate used for the manufacture of a solar cell.

### SUMMARY

According to an embodiment, a processing line for processing a substrate used for the manufacture of a solar cell is provided. The processing line includes a first station including a first chamber. The processing line includes a second station. The second station includes a second chamber and a printer in the second chamber. The processing line includes a linear guide extending at least from the first chamber to the second chamber. The processing line includes a robot arm. The processing line includes an actuator assembly to move the robot arm along the linear guide. The robot arm is movable along the linear guide to a position inside the first chamber. The robot arm is movable along the linear guide to a position inside the second chamber. The first chamber is a storage chamber for storing one or more consumables for the printer or one or more replacement parts for the printer or one or more servicing tools for servicing the printer or any combination thereof.

According to a further embodiment, a method of operating a processing line for processing a substrate used for the manufacture of a solar cell is provided. The method includes moving a robot arm along a linear guide to a position inside a first chamber of a first station of the processing line. The method includes moving the robot arm along the linear guide to a position inside a second chamber of a second station of the processing line. The second station includes the second chamber and a printer in the second chamber. The method includes storing, in the first chamber, a consumable for the printer or a replacement part for the printer or a servicing tool for servicing the printer or any combination thereof.

According to a further embodiment, a method of operating a processing line for processing a substrate used for the manufacture of a solar cell is provided. The method includes storing, in a first chamber of a first station of the processing line, any of the following: a consumable for a printer, or a replacement part for a printer, or a servicing tool for servicing a printer, or any combination thereof. The method includes mounting at least one of the consumable, the replacement part and the servicing tool to a robot arm. The method includes moving the robot arm holding the at least one of the consumable, the replacement part and the servicing tool from the first chamber to a second chamber of a second station of the processing line. The printer is disposed in the second chamber. The robot arm is moved along a linear guide extending between the first chamber and the second chamber. The method includes performing, by the robot arm, a servicing operation of the printer using the at least one of the consumable, the replacement part and the servicing tool.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. The methods for operating the described apparatus include method aspects for carrying out every function of the apparatus.

### BRIEF DESCRIPTION OF THE DRAWINGS

A full and enabling disclosure to one of ordinary skill in the art is set forth more particularly in the remainder of the specification including reference to the accompanying drawings wherein:
FIGs. 1-2 illustrate a processing line for processing a substrate used for the manufacture of a solar cell according to embodiments described herein, wherein a robot arm moves from a position inside a first chamber to a position inside a second chamber;
FIG. 3 shows a screen printer;
FIG. 4 shows a robot arm supported by a linear guide of a processing line according to embodiments described herein;
FIGs. 5-7 shows a robot arm moving along a linear guide into a chamber of a processing line according to embodiments described herein, followed by closing the chamber;
FIGs. 8-10 show a robot arm moving along a linear guide to pass through a chamber of a processing line according to embodiments described herein;
FIGs. 11-13 show a robot arm that retrieves one or more items in a first chamber of a processing line according to embodiments described herein and transports the one or more items along a linear guide to a second chamber of the processing line;
FIG. 14 shows a paste dispenser for dispensing a printing paste;
FIG. 15 shows a plurality of paste dispensers being stored in a first chamber of a processing line according to embodiments described herein;
FIG. 16 shows a robot arm transporting a replacement screen for a printer along a linear guide of a processing line according to embodiments described herein;
FIG. 17 shows a support for transporting a replacement screen for a printer along a linear guide of a processing line according to embodiments described herein;
FIG. 18 shows a robot arm handling a replacement screen for a printer of a processing line according to embodiments described herein;
FIG. 19 shows a processing line according to embodiments described herein having three chambers connected by a linear guide; and
FIG. 20 shows a processing line according to embodiments described herein.

### DETAILED DESCRIPTION

Reference will now be made in detail to the various embodiments, one or more examples of which are illustrated in the figures. Within the following description of the drawings, the same reference numbers refer to same components. Generally, only the differences with respect to individual embodiments are described. Each example is provided by way of explanation and is not meant as a limitation. Further, features illustrated or described as part of one embodiment can be used on or in conjunction with other embodiments to yield yet a further embodiment. It is intended that the description includes such modifications and variations.

The drawings are schematic drawings which are not drawn to scale. Some elements in the drawings may have dimensions which are exaggerated for the purpose of highlighting aspects of the present disclosure and/or for the sake of clarity of presentation.

A substrate as described herein may be a substrate used for the manufacture of a solar cell. A substrate may be a flat piece of material. A substrate may be a wafer. A substrate may be a semiconductor substrate, such as a silicon substrate. A substrate as described herein may be processed by the processing line according to embodiments described herein to print one or more patterns on the substrate, e.g. one or more patterns including busbars and/or fingers. The processing of a substrate by the processing line may result, at the end of the processing line, in a finished solar cell, i.e. a solar cell having fingers and busbars printed thereon.

A processing line, as described herein, may include a plurality of stations for processing a substrate used for the manufacture of a solar cell. For example, the substrate may be processed sequentially by the respective stations of the processing line. The substrate may be transported along the stations. For example, the substrate may be processed in a first station of the processing line. After processing in the first station, the substrate may be transported from the first station to a second station, e.g. by way of a conveyor. The substrate may be subsequently processed in the second station. In some embodiments, the substrate may subsequently be processed in further stations of the processing line, such as e.g. a third station, a fourth station, and so on. A processing line according to embodiments described herein may be a metallization line for manufacturing a solar cell.

According to an embodiment, a processing line for processing a substrate used for the manufacture of a solar cell is provided. The processing line includes a first station including a first chamber. The processing line includes a second station. The second station includes a second chamber and a printer in the second chamber. The processing line includes a linear guide extending at least from the first chamber to the second chamber. The processing line includes a robot arm. The processing line includes an actuator assembly to move the robot arm along the linear guide. The robot arm is movable along the linear guide to a position inside the first chamber. The robot arm is movable along the linear guide to a position inside the second chamber.

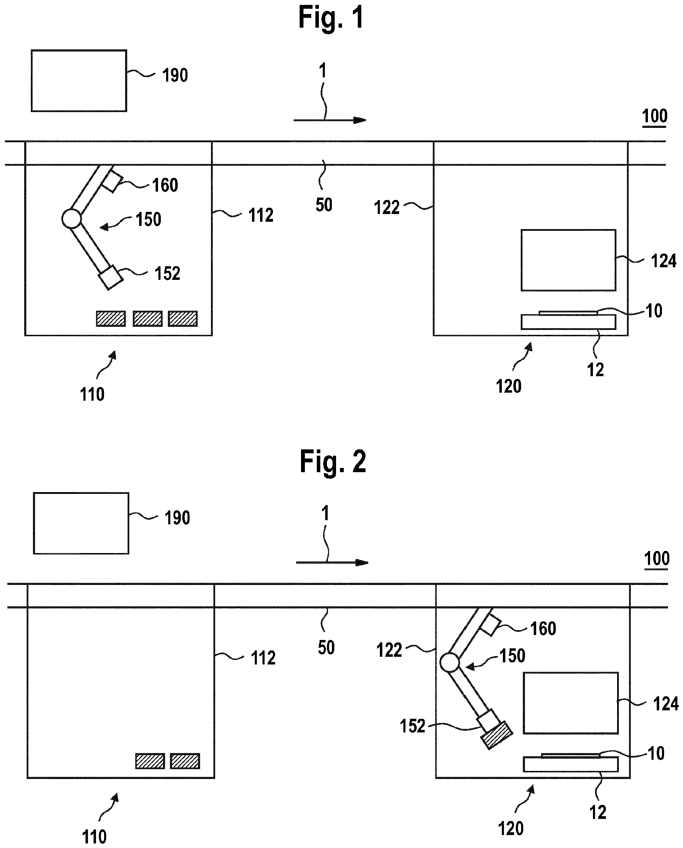

Figs. 1-2 shows an example of a processing line 100 according to embodiments described herein. The processing line 100 includes a first station 110 including a first chamber 112. The processing line 100 includes a second station 120 including a second chamber 122 and a printer 124 in the second chamber 122. The printer 124 may be configured for printing one or more features (for example a pattern including fingers and/or busbars) on a substrate 10 used for the manufacture of a solar cell. The substrate 10 may be supported by a substrate support 12. The processing line 100 includes a linear guide 50 extending at least between the first chamber 112 and the second chamber 122. The linear guide 50, or at least a portion thereof, may extend in a first direction 1, which may be a horizontal direction. The processing line 100 includes a robot arm 150 and an actuator assembly 160 to move the robot arm 150 along the linear guide 50. The robot arm 150 is movable along the linear guide 50 to a position inside the first chamber 112, as illustrated in Fig. 1. The robot arm 150 is movable along the linear guide 50 to a position inside the second chamber 122, as illustrated in Fig. 2.

A processing line 100 according to embodiments described herein may include a controller 190. The controller 190 may control the operation of the robot arm 150 and/or the movement of the robot arm 150 along the linear guide 50. The controller may be a single centralized controller or may be a distributed controller including a plurality of individual control units. A controller may include a central processing unit (CPU), a memory and, for example, support circuits. To facilitate control of the robot arm, of the actuator assembly or of other parts of the processing line, the CPU may be one of any form of general-purpose computer processor that can be used in an industrial setting for controlling various components and sub-processors. The memory may be coupled to the CPU. The memory, or a computer readable medium, may be one or more readily available memory devices such as random-access memory, read only memory, a floppy disk, a hard disk, or any other form of digital storage either local or remote. The support circuits may be coupled to the CPU for supporting the processor in a conventional manner. These circuits include cache, power supplies, clock circuits, input/output circuitry and related subsystems, and the like.

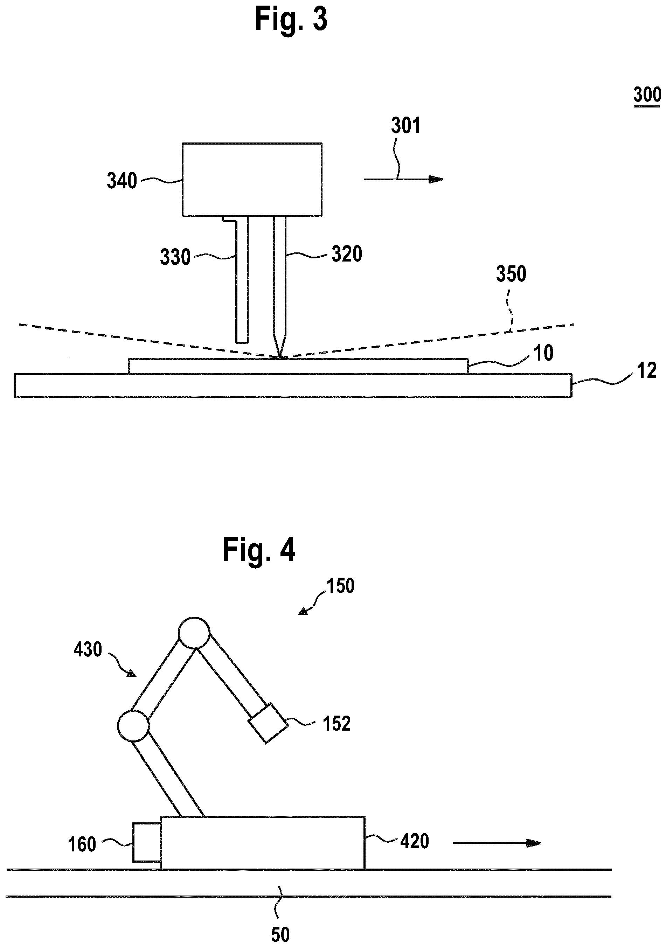

Figs. 1-2 show the linear guide 50 being mounted to upper portions of the first chamber 112 and the second chamber 122 so that the linear guide 50 supports the robot arm 150 from above, i.e. the robot arm 150 is disposed and moves below the linear guide 50. Figs. 1-2 are illustrative examples and the disclosure shall not be limited thereto. The linear guide 50 may be mounted to lower portions (e.g. floor portions) of the first chamber 112 and the second chamber 122, and may support the robot arm 150 from below, such as for example the configuration shown in Fig. 4.

In light of the above, embodiments described herein can provide for an automation of the printing of fingers and busbars on substrates used for the manufacture of solar cells. The metallization process of solar cells can be automated. Embodiments described herein thereby provide an advantage over conventional metallization lines, where the printing process is still strongly dependent on human operators.

Further, embodiments described herein provide a linear guide allowing the robot arm 150 to travel fast and unhindered between the first chamber and the second chamber. The robot arm 150 can travel between the chambers along a direct path, without having to make any detours by going around the chambers. In other words, the robot arm can stay within the processing line. Accordingly, the robot arm can travel at a high speed between the chambers without the risk of endangering human operators.

Embodiments described herein thereby provide advantages over conventional collaborative robots (cobots). The latter robots do not move by way of a linear guide, but have e.g. a set of wheels that allow them to move around over the work floor. Such cobots cannot travel between chambers along a direct path, but have to make a detour by going around the chambers, thereby increasing the distance travelled and the travel time. Further, such cobots normally move at an inherently low speed since care must be taken not to collide with the human operators that are present in the vicinity of the processing line. By comparison, the robot arm moving along the linear guide according to embodiments described herein stays on a direct path inside the processing line when travelling between the chambers, so that there is no risk of running into human operators. Accordingly, the robot arm can move at higher speeds as compared to a cobot.

Fig. 3 shows an example of a screen printer 300. The screen printer 300 shown in Fig. 3 may be the printer in the second chamber, the printer in the third chamber described further below, or any other printer of the processing line. A screen printer 300 may include a screen 350, e.g. a mesh screen or stencil screen. A screen printer 300 may include a print head 340 that may be movable over the screen 350 in a horizontal direction 301. A substrate 10 may be supported by a substrate support 12 below the screen 350. The print head 340 may include a pressure application instrument 320, e.g. a squeegee. The pressure application instrument 320 may apply a downward pressure to the screen 350 to transfer a printing material (not shown), e.g. a printing paste, from the screen 350 to the substrate 10. While the pressure application instrument 320 applies the pressure to the screen 350, the print head 340 may move in the horizontal direction 301 from one side of the screen 350 to an opposite side of the screen 350 to perform a printing stroke. One or more features, in particular a pattern (e.g. a conductive pattern comprising fingers and/or busbars) can be printed on the substrate 10 during the printing stroke. The print head 340 may include a floodbar 330. The floodbar 330 may be configured for preparing the printing material on the screen 350 during a movement of the print head 340 over the screen 350. The floodbar 330 may provide a substantially uniform layer of printing material on the screen 350. The layer of printing material may thereafter be transferred from the screen 350 to the substrate 10 in a subsequent printing stroke. Fig. 3 is an example of a screen printer for the purpose of illustration and the disclosure shall not be limited thereto. For example, instead of a print head including both a floodbar and a pressure application instrument, two separate, independently movable print heads may be provided, a first print head having a pressure application instrument and a second print head having a floodbar. Further modifications of the screen printer may be considered.

A printer as described herein (such as the printer in the second chamber, the printer in the third chamber, or any other printer of the processing line) may be configured for printing one or more features, particularly a pattern, on a substrate used for the manufacture of a solar cell. A printer may be configured for printing a conductive pattern, such as a pattern comprising one or more fingers and/or one or more busbars, on the substrate.

A printer may be a screen printer. The printer may include a screen. A printing material, such as a printing paste, may be provided on the screen. The printer may include a pressure application instrument, such as a squeegee or doctor blade, for applying a pressure to the screen to transfer the printing material from the screen to the substrate. The pressure application instrument may be configured to move over the screen from a first end of the screen to a second end of the screen to perform a printing stroke. In the printing stroke, one or more features, e.g. busbars and/or fingers, may be printed on the substrate. The example of a screen printer is given by way of illustration and the disclosure is not limited thereto. A printer can be a different kind of printer, such as, for example, an inkjet printer, an aerosol-jet printer, a spray printer, a micro-dispensing printer, or a pattern-transfer printer.

The linear guide as described herein may define a transport path of the robot arm. The transport path may be disposed in a horizontal plane. The transport path may be a straight transport path extending along a horizontal direction or may be a curved transport path disposed in a horizontal plane. At least a portion of the linear guide may extend in a horizontal direction. The linear guide may extend at least from a first position inside the first chamber to a second position inside the second chamber. The second position may be spaced apart from the first position in a horizontal direction. The linear guide may be configured to transport the robot arm from the first position to the second position.

The linear guide may include one or more rails. The robot arm may be supported by, mounted to or attached to (in particular, movably attached to) the linear guide. The linear guide may support the robot arm from above or from below.

A portion of the linear guide may be disposed inside the first chamber (e.g., the portion may be disposed at a ceiling of the first chamber or at a floor of the first chamber) for supporting the robot arm inside the first chamber and/or for allowing a transportation of the robot arm within the first chamber along the portion of the linear guide.

A portion of the linear guide may be disposed inside the second chamber (e.g., the portion may be disposed at a ceiling of the second chamber or at a floor of the second chamber) for supporting the robot arm inside the second chamber and/or for allowing a transportation of the robot arm within the second chamber along the portion of the linear guide. Likewise, a portion of the linear guide may be disposed in the third chamber as described herein.

A robot arm as described herein may include movable links connected to each other by one or more joints. The robot arm may include an end effector (or multiple end effectors). For example, the robot arm 150 shown in Figs. 1-2 has an end effector 152. An end effector may be coupled to at least one link of the robot arm. The processing line according to embodiments described herein may include a controller, such as controller 190 shown in Figs. 1-2. The robot arm may be connected to the controller to operate the robot arm. Operating the robot arm may include, for example, moving one or more links of the robot arm to change the position of the end effector, engaging an object with the end effector, and the like.

Fig. 4 shows an example of a robot arm 150 supported from below by a linear guide 50. The linear guide 50 may be disposed on a floor portion of the first chamber and/or a floor portion of the second chamber. The robot arm 150 may be disposed above or upon the linear guide 50. The robot arm 150 may include a base portion 420 mounted to the linear guide 50. The base portion 420 may be configured for supporting certain items, such as on-board stored tools, a replacement screen for a printer, and the like, as described in further detail below. An arm portion 430 of the robot arm, including the end effector 152, links and one or more joints connecting the links, may be mounted on the base portion 420. The configuration shown in Fig. 4 is exemplary and the disclosure shall not be limited thereto. For example, a base portion may also be included in a robot arm supported from above by a linear guide, such as the robot arm 150 and linear guide 50 shown in Figs. 1-2.

A robot arm as described herein may include a base portion. The base portion may be mounted to the linear guide. The robot arm may include an arm portion supported by the base portion. The arm portion may include the links, the one or more joints and the end effector(s) of the robot arm.

The actuator assembly may be connected to the robot arm to move the robot arm along the linear guide, e.g. from a position inside the first chamber to a position inside the second chamber. The actuator assembly may be connected to the controller to move the robot arm along the linear guide. The actuator assembly may include one or more actuators. The one or more actuators may include one or more motors, such as one or more electric motors. For example, the robot arm may include a base portion having idle and driving wheels mounted thereon for moving the robot arm along the linear guide. The driving wheel can be driven by an electric motor that may be on board of the base portion. In another example, the linear guide may include a movable toothed belt driven by a stationary motor (e.g. an electric motor). The base portion of the robot arm may engage the toothed belt for moving the robot arm along the linear guide. In another example, the base portion may carry an electric motor configured to drive a wheel that engages a stationary toothed belt that is part of the linear guide.

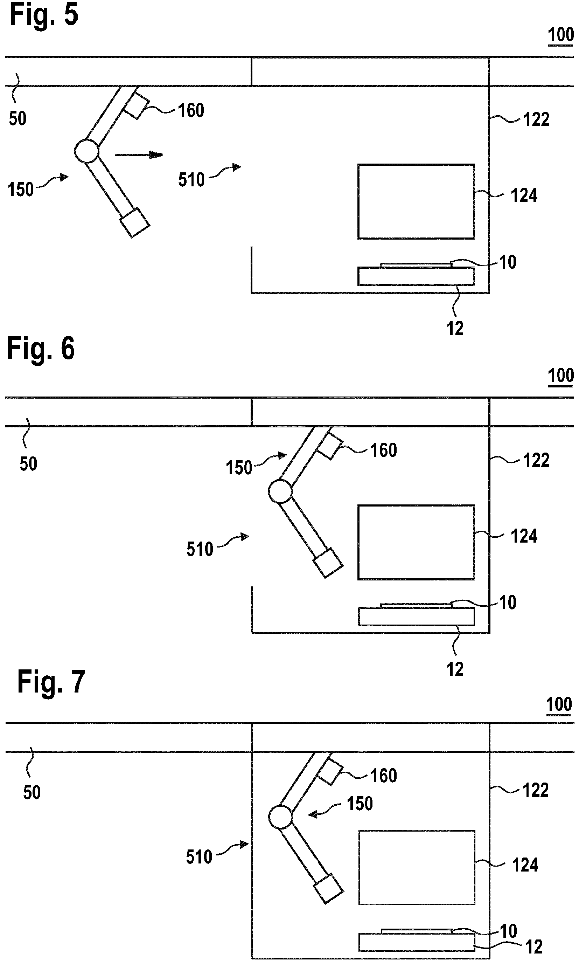

Figs. 5-7 illustrate a robot arm 150 moving along the linear guide 50 from a position outside the second chamber 122 to a position inside the second chamber 122. The second chamber 122 may have a closable opening 510, e.g. a door or window, at a first side of the second chamber 122 for letting the robot arm 150 enter the second chamber 122. The closable opening 510 may be provided in a sidewall of the second chamber 122. Fig. 5 shows the robot arm supported by the linear guide 50 outside the second chamber 122. In Fig. 5, the second chamber 122 is open. The closable opening 510 is open. The robot arm 150, more specifically the entire robot arm 150, that moves along the linear guide 50 may pass through the closable opening 510 to enter the second chamber 122. Fig. 6 shows the robot arm 150 after the robot arm 150 has entered the second chamber 122 through the closable opening 510. In Fig. 6, the robot arm 150 is supported by the linear guide 50 inside the second chamber 122. After the robot arm 150 has entered the second chamber, the closable opening 510 may be closed, as shown in Fig. 7. In Fig. 7, the second chamber 122 is closed.

The movement of the robot arm along the linear guide as shown in Figs. 5-7 may be provided by the actuator assembly, and/or may be controlled by the controller.

For the sake of concreteness, Figs. 5-7 show the robot arm entering the second chamber 122. The same applies to the robot arm entering the first chamber, the third chamber, or any other chamber of the processing line.

According to embodiments described herein, the robot arm is movable along the linear guide to a position inside the first chamber and to a position inside the second chamber. That the robot arm is inside a chamber can include that the chamber encloses the entire robot arm. A first portion of the linear guide may be disposed inside the chamber. The robot arm inside the chamber may be supported by the first portion of the linear guide. The robot arm inside the chamber may be movable within the chamber (e.g. from a first position inside the chamber to a second position inside the chamber) along the first portion of the linear guide.

A chamber, such as the second chamber (but not limited thereto, i.e. the chamber can be any other chamber of the processing line, such as the first chamber or the third chamber) may have a first side where the robot arm enters the chamber. The first side may have a closable opening, e.g. a closable window or door in a sidewall of the chamber, for letting the robot arm enter the chamber. When the robot arm is inside the chamber, the closable opening may be closed.

The chamber may be closable, or closed, while the robot arm is inside the chamber. A closed chamber (e.g. the second chamber 122 shown in Fig. 7) can be understood as a chamber where all doors, windows, and the like, that are normally used (by a human operator or by a part of an apparatus) to access the interior of the chamber (e.g. for performing tasks such as inspection, maintenance, repair and the like) from the outside are closed. If the chamber includes a printer (such as the second chamber, the third chamber, or any other chamber used for printing), after closing the chamber the printer may be operated while the robot arm is inside the chamber. In particular, the printer may be operated while the robot arm inside the closed chamber performs a servicing operation of the printer. Operating the printer may include performing a printing process, e.g. printing a conductive pattern on a substrate, using the printer.

A robot arm that is inside a chamber, as described herein, attends to the apparatus(es) in the chamber (e.g. a printer in the chamber) from within the chamber. While the robot arm operates inside the chamber, the chamber can be in a closed state, as described above. Such a robot arm can be distinguished from a robot (e.g. a cobot) that attends to the apparatus(es) in the chamber from the outside, i.e. a robot arm that is essentially disposed outside the chamber and where only a part of the robot arm reaches into the chamber for attending to the apparatus(es) in the chamber. In the latter case, the chamber cannot be closed while the robot arm reaches into the chamber from the outside.

That the chamber is closable while the robot arm is inside the chamber has the advantage that the robot arm may perform operations in the closed chamber without the risk of endangering human operators that may be present in the vicinity of the chamber. In particular, the robot arm may perform various tasks at a high speed inside the closed chamber, without the risk of hurting any human operators. The efficiency of the robot arm can be increased. A further advantage is that, once the chamber is closed, the printer in the chamber may start operation, e.g. may start a printing process. That is to say, the printer may operate while the robot arm is inside the chamber. Accordingly, the robot arm can perform various tasks, e.g. a servicing operation of the printer, while the printer is operating.

The second chamber may be closable, or closed, when the robot arm is inside the second chamber.

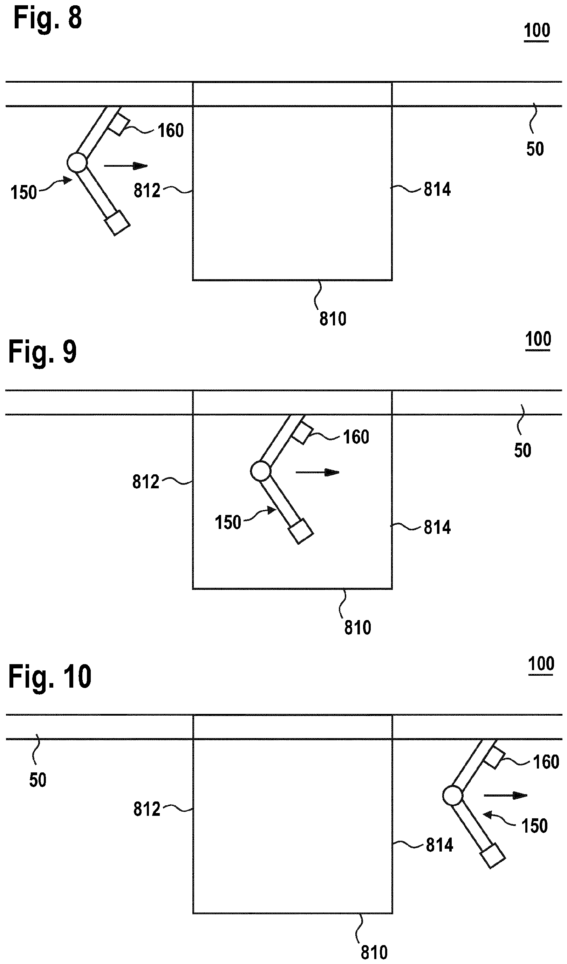

Figs. 8-10 show an example of the robot arm 150 moving along the linear guide 50 to pass through a chamber 810. The chamber 810 may be the first chamber, the second chamber, the third chamber, or any other chamber of the processing line.

Fig. 8 shows the robot arm 150 supported by the linear guide 50 on a first side of the chamber 810 (the first side being the left side of the chamber 810 in Figs. 8-10). The robot arm 150 is outside the chamber 810 and is moving along the linear guide 50 towards a sidewall 812 on the first side of the chamber 810, as indicated by the arrow. The sidewall 812 of the chamber 810 may have an opening to let the robot arm 150 pass therethrough, for example a closable opening similar to the closable opening 510 in Figs. 5-7. For ease of presentation, the opening is not shown in Figs. 8-10. The robot arm 150 may enter the chamber 810 on the first side of the chamber 810 by moving along the linear guide 50 through the opening in the sidewall 812.

Fig. 9 shows the robot arm 150 after the robot arm 150 has entered the chamber 810 at the first side of the chamber 810. The robot arm 150 is supported by the linear guide 50 inside the chamber 810. The robot arm 150 inside the chamber 810 may, for example, perform a servicing operation of a printer (not shown) inside the chamber 810. The robot arm 150 may move along the linear guide 50 within the chamber 810, either in one direction or back and forth, and/or may be stationary with respect to the linear guide 50 for a certain amount of time. When the task(s) of the robot arm 150 in the chamber 810 have been completed, the robot arm 150 may move out of the chamber 810 at a second side of the chamber 810 (in Figs. 8-10, the second side is the right side of the chamber 810). The robot arm 150 inside the chamber 810 may move along the linear guide 50 to a sidewall 814 at the second side of the chamber 810, as indicated by the arrow in Fig. 9. The sidewall 814 and the sidewall 812 may be on opposite sides of the chamber 810. The sidewall 814 of the chamber 810 may have an opening to let the robot arm 150 pass therethrough, for example a closable opening similar to the closable opening 510 in Figs. 5-7. For ease of presentation, the opening is not shown in Figs. 8-10. The robot arm 150 moving along the linear guide 50 may exit the chamber 810 at the second side of the chamber 810 by passing through the opening in the sidewall 814.

Fig. 10 shows the robot arm 150 supported by the linear guide 50 on the second side of the chamber 810 after the robot arm 150 has exited the chamber 810. The robot arm 150 is outside the chamber 810 and may move along the linear guide 50 away from the chamber 810, as indicated by the arrow.

The movement of the robot arm along the linear guide as shown in Figs. 8-10 may be provided by the actuator assembly, and/or may be controlled by the controller.

The processing line may include a chamber, wherein the chamber may be the first chamber, the second chamber, or a further chamber of the processing line. The robot arm may be movable along the linear guide into the chamber at a first side of the chamber. For example, the robot arm may be movable into the chamber along the linear guide through an opening in a first sidewall at the first side of the chamber. The robot arm may be movable along the linear guide from the first side of the chamber to a second side of the chamber to pass through the chamber. The second side of the chamber may be opposite the first side of the chamber. The chamber may include a second sidewall at the second side of the chamber. The robot arm may be movable along the linear guide out of the chamber at the second side of the chamber. For example, the robot arm may be movable out of the chamber along the linear guide through an opening in the second sidewall. The linear guide may have a first portion disposed outside the chamber at the first side of the chamber, a second portion disposed outside the chamber at the second side of the chamber, and a third portion between the first portion and the second portion. The third portion may be disposed inside the chamber. In one example, the chamber may be the second chamber. The robot arm moving along the linear guide may pass through the second chamber and continue to another chamber of the processing line downstream of the second chamber. In another example, the chamber may be a further chamber between the first chamber and the second chamber. For example, the further chamber may be the third chamber as described herein. The robot arm may move along the linear guide from the first chamber through the further chamber and into the second chamber.

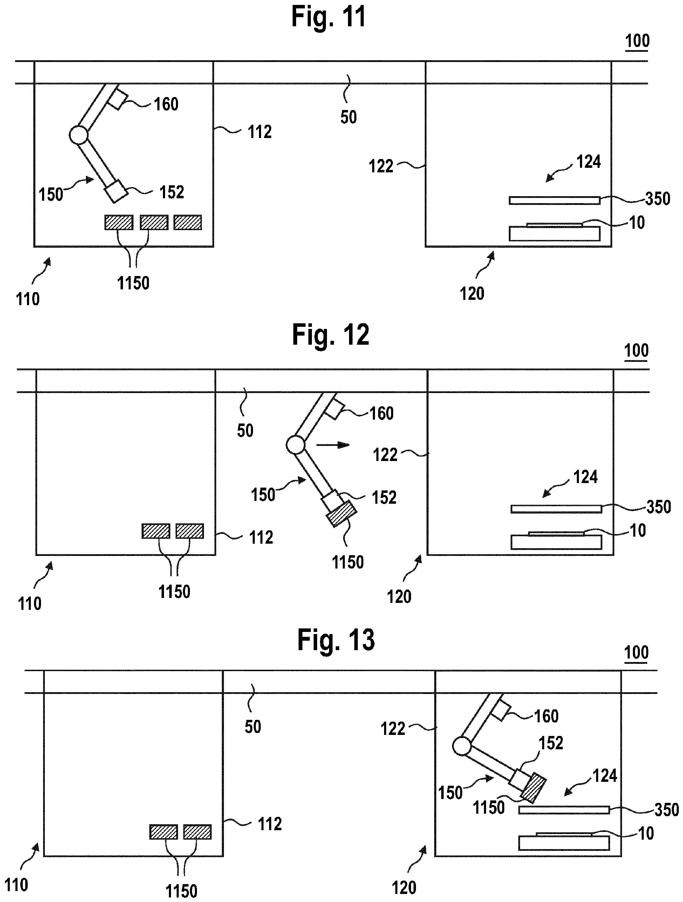

Figs. 11-13 show a set of items 1150 that may be stored in the first chamber 112. The set of items 1150 may include one or more consumables for a printer, or one or more replacement parts for a printer, or one or more servicing tools for servicing a printer, or any combination thereof. As shown in Fig. 11, the robot arm 150 supported by the linear guide 50 inside the first chamber 112 may retrieve an item 1150 (or several items 1150). For example, the item 1150 may be picked up by an end effector 152 of the robot arm 150. The item 1150 may be a consumable for a printer, a replacement part for a printer, or a servicing tool for a printer. For example, the item 1150 may be a paste dispenser for dispensing a printing paste, or a replacement screen for a printer.

As shown in Fig. 12, the robot arm 150 may transport the retrieved item 1150 from the first chamber 112 to the second chamber 122 by moving along the linear guide 50. During said transportation, the item 1150 may be held by the end effector 152 of the robot (as shown in Fig. 12), may alternatively be supported by a base portion of the robot arm, or may be transported by the robot arm in a different way.

As shown in Fig. 13, the robot arm 150 may perform a servicing operation of the printer 124 in the second chamber 122 using the retrieved item 1150. The servicing operation may be performed while the printer 124 is operating (e.g. during a printing process) or while the printer 124 is offline. The printer 124 shown in Figs. 11-13 is a screen printer having a screen 350. For example, if the item 1150 is a paste dispenser, the robot arm 150 inside the second chamber 122 may operate the paste dispenser to dispense a printing paste on the screen 350 of the printer 124. In another example, if the item 1150 is a replacement screen, the robot arm 150 inside the second chamber 122 may replace the screen 350 (e.g. if the screen 350 is broken or worn out) by the replacement screen. The disclosure shall not be limited to screen printers, and other types of printers may be considered. Further, the retrieved item 1150 is not limited to a paste dispenser or a replacement screen, and can be any consumable, replacement part or servicing tool.

The movement of the robot arm along the linear guide as shown in Figs. 11-13 may be provided by the actuator assembly, and/or may be controlled by the controller. The operation(s) performed by the robot arm inside the first chamber or the second chamber as illustrated in Figs. 11-13 may be performed under the control of the controller.

A consumable for a printer may be understood as a material or other object that is consumed, or used up, by the printer during normal operation of the printer, and that needs to be re-supplied to the printer recurrently. Examples of consumables include a printing material, e.g. a printing paste, used by the printer for printing, or a sheet of paper used by the printer.

A replacement part for a printer may be understood as a part, or component, that is used to replace a corresponding part in the printer which is worn out, malfunctioning, broken, or the like. Examples of replacement parts include a screen for the printer to perform screen printing, a pressure application instrument (such as a squeegee), a floodbar, a cleaning pad, and the like. Some replacement parts may also be regarded as consumables. For example, a squeegee or a screen may also be understood as consumables.

A servicing tool for a printer may be understood as a tool handled by the robot arm for performing a servicing operation of the printer. Examples of servicing tools include a paste dispenser for dispensing a printing paste for the printer, an air blower or air suction device (which may be handled by the robot arm for removing pieces or debris of a substrate after substrate breakage), a special-purpose end effector for handling a replacement screen for the printer, a tool for engaging a fastener (e.g. a screw driver), a gripper for gripping a substrate, a gripper for gripping a sheet of paper, a cleaning brush for removing printing material (e.g. for cleaning residuals of printing paste), an inspection system such as a camera (e.g. a CCD camera), and the like.

The first chamber may be a storage chamber for storing one or more consumables for a printer, or one or more replacement parts for a printer, or one or more servicing tools for servicing a printer, or any combination thereof. The one or more consumables, the one or more replacement parts and/or the servicing tools may be for the printer in the second chamber, for the printer in the third chamber, or for any other printer of the processing line.

The controller of the processing line may be configured to move, or transport, the robot arm to a position inside the first chamber (e.g. the position of the robot arm shown in Fig. 11). The controller may be configured to instruct the robot arm inside the first chamber to retrieve one or more items that are stored in the first chamber. The one or more items may include a consumable for a printer, or a replacement part for a printer, or a servicing tool for servicing a printer, or any combination thereof. That an item is retrieved by the robot arm can include that the item is picked up by the robot arm (e.g. using an end effector of the robot arm), that the robot arm engages the item to connect or mount the item to the robot arm, and the like.

The robot arm may be configured for transporting the one or more retrieved items along the linear guide from the first chamber to the second chamber (as illustrated for example in Fig. 12). The controller may be configured to move, or transport, the robot arm carrying the one or more retrieved items along the linear guide from the first chamber to a position inside the second chamber.

The robot arm may move along the linear guide to the first chamber to retrieve the one or more items and/or may transport the one or more retrieved items along the linear guide from the first chamber to the second chamber in response to a signal that a servicing operation is to be performed in the second chamber. The signal may be triggered by a condition of the printer in the second chamber. The condition of the printer may, for example, include a substrate breakage, a broken or worn out screen, running out of printing paste, and the like.

The robot arm may be configured for performing a servicing operation of the printer in the second chamber using the one or more retrieved items (as illustrated in Fig. 13). The servicing operation of the printer may be performed while the robot arm is inside the second chamber. The servicing operation may be performed while the printer is operating. The controller may be configured to instruct the robot arm to perform the servicing operation.

As described above, one or more servicing tools for a printer may be stored in the first chamber. Additionally or alternatively, one or more other servicing tools may be on-board stored tools of the robot arm. An on-board stored tool may be a tool stored on board of the robot arm (e.g. at, in or on a base portion of the robot arm, for example base portion 420 shown in Fig. 4). When a servicing operating of a printer is to be performed using an on-board stored tool, the robot arm does not need to first travel to the first chamber to retrieve the on-board stored tool, since the tool in question is already on board of the robot arm, and the robot arm may travel directly to the printer to perform the servicing operation. That an on-board stored tool is stored by the robot arm means that the tool in question is kept by the robot arm for an extended period of time (which may be much longer than the time needed by the robot arm to travel from the first chamber to another chamber) without being actively used by the robot arm. An on-board stored tool may already be stored on board of the robot arm, without being actively used, before a signal is issued that a servicing operation requiring the tool in question is to be performed. Examples of on-board stored tools include a gripper for gripping a substrate, an air blower or air suction device, and the like.

Any of the following may be part of, or mountable to, the robot arm: a gripper for gripping the substrate, or an inspection system, or an air blower, or an air suction device, or a tool for engaging a fastener, or a gripper for gripping a sheet of paper, or a cleaning brush for removing printing paste, or any combination thereof. At least some of the forgoing items may be stored in the first chamber and retrieved by the robot arm from the first chamber. At least some of the items may be on-board stored tools of the robot arm.

A servicing operation of a printer, such as the printer in the second chamber, the printer in the third chamber, or any other printer of the processing line, can be understood as an operation, or set of operations, for performing inspection, maintenance, repair, and the like, of the printer. A servicing operation of a printer may include, for example, dispensing a printing material (e.g. a printing paste) to the printer, replacing a screen of the printer, detecting and/or removing pieces or debris of a substrate after substrate breakage, replacing a pressure application instrument (e.g. a squeegee) of the printer, replacing a floodbar of the printer, replacing a sheet of paper of the printer, cleaning paste residuals in the printer or in the vicinity thereof, performing inspection of the printer or of a printing process carried out by the printer, and the like; or any combination thereof.

A servicing operation performed by the robot arm need not specifically be a servicing operation of a printer. The robot arm may perform a servicing operation in a chamber that is not a printing chamber. The robot arm may retrieve one or more items from the first chamber as described above, and transport the one or more retrieved items to a chamber of the processing line, wherein the chamber may not be a printing chamber. Using the one or more retrieved items, the robot arm may be configured for performing a servicing operation other than a servicing operation of a printer. A servicing operation performed by the robot arm may include inspection, maintenance, repair, and the like, of components, apparatuses or devices, other than printers. For example, the robot arm may be configured for detecting and/or removing pieces or debris of a substrate after substrate breakage, wherein the pieces or debris may be detected/removed either at a printer or anywhere else along the processing line.

In light of the above, embodiments described herein provide for a fast and fully automated method for performing servicing operations on a processing line for processing a substrate used for the manufacture of a solar cell.

In the following, several examples of servicing operations are described in further detail.

An example of a service operation regards the dispensing of printing material, e.g. printing paste, to a printer.

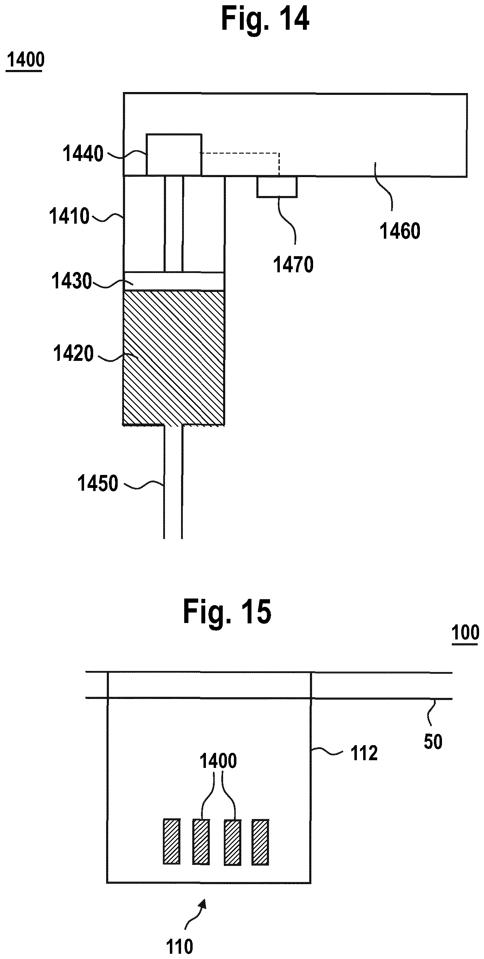

Fig. 14 shows an example of a paste dispenser 1400 for dispensing a printing paste. The paste dispenser 1400 may include a container 1410 for receiving a printing paste 1420. The paste dispenser 1400 may include a piston 1430 in the container 1410. The paste dispenser 1400 may include a tube 1450 that is fluidly coupled to the container 1410. The piston 1430 may move (downward, in the example shown in Fig. 14) to push a dose of printing paste out of the container 1410 and through the tube 1450, so that the dose of printing paste can be discharged from the paste dispenser 1400. The piston 1430 may be moved by an actuator 1440. The paste dispenser 1400 may be connectable to the robot arm 150 as described herein. For example, an end effector of the robot arm 150 may be configured to grip the paste dispenser 1400 at a handle portion 1460 of the paste dispenser 1400. The robot arm 150, e.g. the end effector of the robot arm 150, may be configured to operate the paste dispenser 1400 to dispense printing paste to a printer, such as the printer in the second chamber, the printer in the third chamber, or any other printer. For example, the end effector of the robot arm 150 may be configured to engage a button or trigger 1470 that is connected to the actuator 1440. By engaging the button or trigger 1470, the actuator 1440 is activated and moves the piston 1430 to push a dose of printing paste out of the container 1410 and through the tube 1450. The dose of printing paste can be discharged.

The paste dispenser 1400 shown in Fig. 14 is an example provided for the purpose of illustration, and the disclosure shall not be limited thereto. Any other printing material dispenser that is operable by a robot arm can be considered.

In light of the above, embodiments described herein provide for a fast and fully automated dispensing of printing material to any printer of the processing line.

The first chamber may be configured for storing a printing material dispenser for dispensing a printing material. The printing material dispenser may be a paste dispenser for dispensing a printing paste. The printing material dispenser may be mountable to the robot arm. The robot arm holding the printing material dispenser may be movable from the first chamber to the second chamber along the linear guide.

A paste dispenser, or paste dispensing gun, may include a container for receiving a printing paste. The container may be configured to contain one or more doses of printing paste for a printer. The paste dispenser may include a discharge mechanism, such as a piston, a pressurized air source, a valve, or the like, for discharging the printing paste from the container to supply the printing paste to the printer. The paste dispenser may be operable by the robot arm. The robot arm may be configured to engage the discharge mechanism to discharge an amount of printing paste from the paste dispenser.

A printing material dispenser such as a paste dispenser, or a plurality of printing material dispensers, may be stored in the first chamber. For example, Fig. 15 shows a plurality of paste dispensers 1400 being stored in the first chamber 112. The temperature in the first chamber may be controlled to a temperature suitable for providing and maintaining target rheological properties of the printing paste in a paste dispenser.

The robot arm may be configured to move along the linear guide into the first chamber. For example, the robot arm may move into the first chamber in response to a signal that a replenishment of printing material, e.g. printing paste, shall be performed for a printer (for example the printer in the second chamber, the printer in the third chamber, or any other printer), or during a preparatory phase in which the printing material dispenser is already retrieved by the robot arm before such a signal is issued. The robot arm may be configured to retrieve, e.g. pick up, a printing material dispenser in the first chamber. For example, an end effector, such as a gripper, of the robot arm may engage the printing material dispenser for mounting the printing material dispenser to the robot arm. The robot arm holding the printing material dispenser may move along the linear guide to transport the printing material dispenser from the first chamber to a position inside a chamber including a printer (such as the second chamber, the third chamber, or any other chamber including a printer). The robot arm inside the chamber may operate the printing material dispenser to dispense an amount of printing material, e.g. printing paste, to the printer in the chamber. For example, if the printing material dispenser is a paste dispenser as described above, an end effector of the robot arm may be configured to operate the piston, the pressurized air mechanism, the valve, or the like, of the paste dispenser to discharge an amount of printing paste from the container of the paste dispenser. The amount of printing paste can be dispensed to the printer.

The robot arm supported by the linear guide inside a chamber (e.g. the second chamber, the third chamber, or any other chamber including a printer) may be configured to operate the printing material dispenser to dispense an amount of printing material to a printer in the chamber. In an initial dispensing operation, the robot arm may operate the printing material dispenser to dispense a first amount of printing material to the printer in the chamber. The initial paste operation may be performed before the printer has started a printing process, e.g. while the printer is offline. The first amount of printing material may be dispensed onto a screen of the printer. The first amount may, for example, consist of several doses of printing material. In an online dispensing operation, that may be formed after the initial dispensing operation, the robot arm may operate the printing material dispenser to dispense a second amount, or "refill" amount, of printing material to the printer in the chamber. The online dispensing operation may be performed while the printer is operating, e.g. during the printing process. The second amount of printing material may be dispensed onto the screen of the printer. The second amount may be smaller than the first amount. The second amount may, for example, consist of a single dose of printing material.

A further example of a servicing operation regards the replacement of a screen of a printer.

The first chamber may be configured for storing a replacement screen for a printer, particularly a screen printer. For example, the one or more of items 1150 shown in Figs. 11-13 may include a replacement screen for a printer. The replacement screen may be a mesh screen or a stencil screen for performing screen printing. The replacement screen may be a new, or unused, screen, i.e. a screen that is in a state suitable for printing.

A replacement screen (or a plurality of replacement screens) may be stored in the first chamber. The robot arm may be configured to move along the linear guide into the first chamber, e.g. in response to a signal that a replacement screen is needed for a printer (for example the printer in the second chamber, the printer in the third chamber, or any other printer). The robot arm may retrieve a replacement screen in the first chamber. The robot arm may be configured to move along the linear guide to transport the replacement screen from the first chamber to a position inside a chamber including a printer (such as the second chamber, the third chamber, or any other chamber including a printer). The printer may include a screen, e.g. a used screen, that shall be replaced. The robot arm inside the chamber may be configured to replace the screen of the printer by the replacement screen. Thereafter, the printer may again be operational, i.e. ready for performing screen printing.

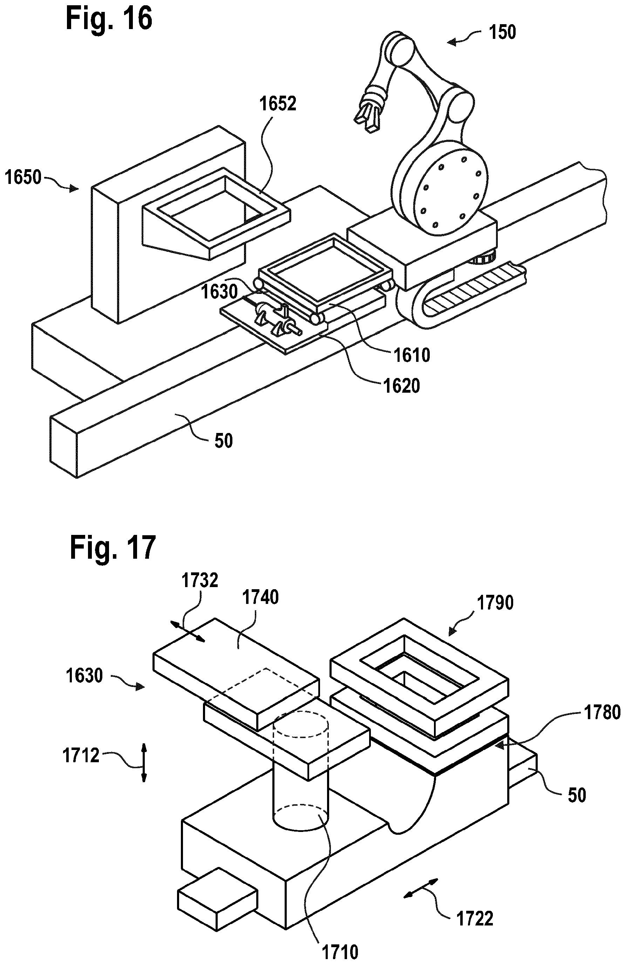

Fig. 16 shows a robot arm 150 transporting a replacement screen 1610. The robot arm may be configured to move along a linear guide 50. The linear guide 50 may support the robot arm 150 from below. At an earlier stage, the replacement screen 1610 may have been retrieved by the robot arm 150 in the first chamber 112.

During transportation along the linear guide 50, the replacement screen 1610 may be disposed on a support 1620. The support 1620 may be disposed on, or be supported by, the linear guide 50. The support 1620 may be part of the robot arm 150, e.g. part of a base portion of the robot arm 150 as described herein. When the replacement screen is retrieved by the robot arm 150 from the first chamber 112, an end effector of the robot arm 150 may pick up the replacement screen 1610 and place the replacement screen 1610 on the support 1620. Alternatively, the support 1620 may initially not be part of the robot arm 150. The support 1620 together with the replacement screen 1610 supported thereon may be stored in the first chamber 112. The robot arm 150 may retrieve the support 1620 supporting the replacement screen 1610 in the first chamber 112, for example, by coupling a portion of the robot arm 150 to the support 1620. Thereafter, the robot arm 150 and the support 1620 with the replacement screen 1610 may travel together along the linear guide 50, e.g. towards a chamber including a printer for performing the screen replacement operation.

When the robot arm 150 has arrived at a printer having a used screen that shall be replaced, such as printer 1650 shown in Fig. 16, the used screen of the printer 1650 may be removed from a print head 1652 of the printer 1650, for example by an end effector of the robot arm 150. The used screen may be stored by the robot arm 150, e.g. on a base portion of the robot arm, on the support 1620, or elsewhere on or at the robot arm 150.

The replacement screen 1610 may be supported by an arm 1630 mounted to the support 1620. After the used screen of the printer 1650 has been removed, the arm 1630 may install the replacement screen 1610 in the printer 1650. When the screen replacement has been completed, the robot arm 150 together with the support 1620 may move along the linear guide 50. For example, the robot arm 150 may transport the support 1620 back to the first chamber 112.

The printer 1650 can be any printer of the processing line, e.g. the printer in the second chamber, the printer in the third chamber, or any other printer.

Fig. 17 shows an example of a support 1620, or shuttle, for supporting and transporting a replacement screen for a printer, e.g. the replacement screen 1610 that is to be installed in the printer 1650 shown in Fig. 16. The support 1620 may be part of the robot arm 150 or may be coupled to the robot arm 150, as described above.

The support 1620 may include a rotary shaft 1710. The support 1620 may include an arm 1630 coupled to the rotary shaft 1710. The arm 1630 may have a first receiving surface 1740 for receiving the replacement screen 1610. The first receiving surface 1740 may be a horizontal surface (within a few degrees, e.g. 5 or 10 degrees).

The rotary shaft 1710 may be movable in a direction 1712 to move the arm 1630, and specifically the first receiving surface 1740, upward and/or downward. The direction 1712 may be a vertical direction. The vertical position of the first receiving surface 1740 with respect to the printer can be adjusted by the vertical movement of the rotary shaft 1710.

The rotary shaft 1710 may be configured to move the arm 1630, and specifically the first receiving surface 1740, over an angle, for example with respect to a vertical rotation axis. An angular position of the first receiving surface 1740 with respect to the printer can be adjusted by the angular movement of the rotary shaft 1710.

The support 1620 may be movable along the linear guide 50 (either as a part of the robot arm or being coupled to the robot arm) to adjust the position of the first receiving surface 1740 in a direction 1722 with respect to the printer. The direction 1722 may be a horizontal direction defined by the linear guide 50.

The arm 1630 may be a telescopic arm that may be configured to extend telescopically. The arm 1630 may include an actuator, e.g. a linear motor, to provide the telescopic movement. The arm 1630 may extend telescopically in a direction 1732. The direction 1732 may be perpendicular to the linear guide 50. The position of the first receiving surface 1740 in the direction 1732 with respect to the printer 1650 can be adjusted by the telescopic movement of the arm 1630. The arm 1630 may extend telescopically to bridge a distance between the support 1620 and the printer 1650. Using the arm 1630, the replacement screen 1610 may be installed in the printer 1650.

The support 1620 may include a second receiving surface 1780 for receiving one or more screens 1790. The one or more screens 1790 may be two or more screens stacked on top of each other. The one or more screens 1790 can include a used screen of a printer. The used screen may be placed on the second receiving surface 1780 (e.g. by an end effector of the robot arm 150) after the used screen has been removed from the printer. Additionally or alternatively, the one or more screens 1790 may include a replacement screen. The replacement screen may be provided on the second receiving surface 1780 before the replacement screen is moved onto the first receiving surface 1740 to perform a screen replacement. The replacement screen may be moved from the second receiving surface 1780 to the first receiving surface 1740, for example by an end effector of the robot arm 150. Thereafter, the screen replacement may be performed by extending the arm 1630 telescopically, as described above.

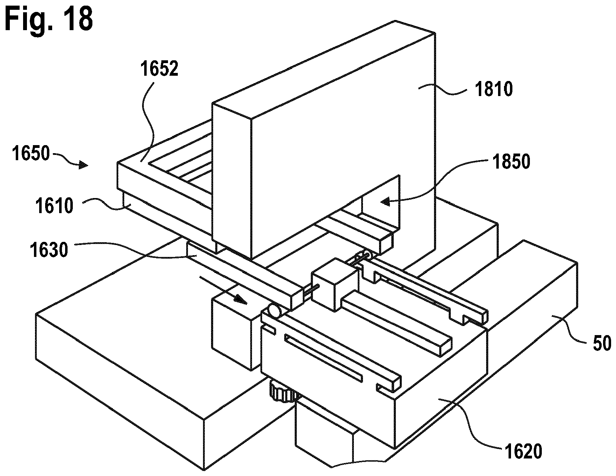

Fig. 18 shows a further illustration of a screen replacement operation. The print head 1652 of the printer 1650 is attached to a wall 1810, e.g. a granite wall. At least a portion of the wall 1810 may be disposed between the print head 1652 and the linear guide 50. An opening 1850 may be provided in the wall 1810 to let the arm 1630 holding a replacement screen 1610 pass therethrough. The arm 1630 holding the replacement screen 1610 may extend telescopically through the opening 1850 to install the replacement screen in the print head 1652, as shown in Fig. 18.

The printer in the second chamber may be a screen printer including a screen. The first chamber may be configured for storing a replacement screen for the printer. The replacement screen may be mountable to the robot arm. The robot arm holding the replacement screen may be movable from the first chamber to the second chamber along the linear guide.

In light of the above, embodiments described herein provide for a fast and fully automated screen replacement for any printer of the processing line.

A further example of a servicing operation regards the detection and/or removal of a broken substrate. A chamber (such as the second chamber, the third chamber, or any other chamber) may include an inspection device, such as a camera. The inspection device may be configured to take an image of a substrate in the chamber (for example under the control of the controller). A breakage of the substrate may be detected based on the image. If a substrate breakage is detected, the controller of the processing line may instruct the robot arm to move to the chamber along the linear guide and remove the pieces of the broken substrate. For example, some pieces of the substrate, e.g. larger pieces, may be gripped by an end effector of the robot arm (e.g. a gripper having suction cups). Other pieces, e.g. smaller pieces of debris of the substrate, may be removed by an air blower or air suction device mounted to the robot arm. The air blower or air suction device may be an on-board stored tool of the robot arm.

The robot arm may be configured to remove one or more substrate pieces, for example using at least one of an end effector, an air blower or an air suction device, in response to a signal that a substrate breakage has occurred in the second chamber.

A further example of a servicing operation regards the replacement of a pressure application instrument, e.g. a squeegee, of a printer in a chamber of the processing line (such as the printer in the second chamber, the printer in the third chamber or any other printer). The pressure application instrument may be replaced when the pressure application instrument is broken or worn out. The robot arm may move to the chamber along the linear guide, e.g. in response to a signal that the pressure application instrument shall be replaced, or as part of a periodic cycle of replacing the pressure application instruments at regular time intervals. The robot arm inside the chamber may remove the pressure application instrument from the printer. For example, the robot arm may carry a tool for removing fasteners, e.g. a screwdriver, for detaching the pressure application instrument from the printer. The robot arm may have an end effector for gripping the detached pressure application instrument. The robot arm may carry a replacement pressure application instrument for replacing the pressure application instrument. The robot arm may replace the pressure application instrument by the replacement pressure application instrument. In a similar manner, the robot arm may be configured for replacing a floodbar of the printer.

A further example of a servicing operation regards the replacement of a sheet of paper of a printer in a chamber of the processing line (such as the printer in the second chamber, the printer in the third chamber or any other printer). The robot arm may move to the chamber along the linear guide, e.g. in response to a signal that the sheet of paper shall be replaced, or as part of a periodic cycle of replacing the paper at regular time intervals. The robot arm inside the chamber may remove the sheet of paper from the printer, e.g. using a gripper having suction cups to grip the sheet of paper. The robot arm may carry a replacement sheet of paper for replacing the sheet of paper. The robot arm may replace the sheet of paper by the replacement sheet of paper.

A further example of a servicing operation regards the removal of printing paste. Undesired amounts of printing paste may be found in a chamber (such as the second chamber, the third chamber or any other printing chamber), for example on the substrate support of a printer in the chamber. For example, the screen of the printer may be broken, and the printing paste may fall down onto the substrate support below the screen. In such an event, a cleaning of the printing paste may be performed. The robot arm may move to the chamber along the linear guide, e.g. in response to a signal that an amount of printing paste shall be removed. The robot arm inside the chamber may perform a cleaning operation to remove the amount of printing paste, e.g. using a cleaning brush carried by the robot arm. In another example, the robot arm may transport a cleaning device (such as a cleaning device including a cleaning brush or cleaning pad) to the chamber and unload the cleaning device in the chamber, e.g. in a position below the screen of the printer in the chamber. The cleaning device may perform a cleaning operation to remove an amount of printing paste.

A further servicing operation may be an inspection operation. The robot arm may carry an inspection device, for example a camera, such as a CCD camera (charge-coupled device camera). The inspection device may be permanently mounted to the robot arm. The robot arm may travel along the linear guide to a location on the processing line, for example in response to a signal that an inspection of said location shall be performed. The location may be a location inside a printing chamber (such as the second chamber, the third chamber or any other printing chamber), a location on the processing line between two chambers, and the like. The robot arm may perform an inspection of the location using the inspection device.

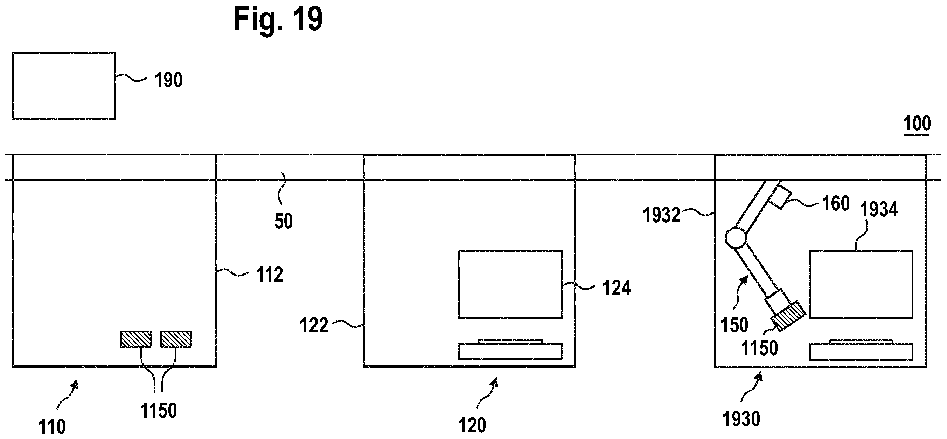

Fig. 19 shows a processing line 100 according to embodiments described herein. The processing line 100 includes a first station 110 and a second station 120 as described herein. As shown in Fig. 19, the processing line 100 may include a third station 1930. The third station 1930 may include a third chamber 1932 and a printer 1934 in the third chamber 1932. The third chamber 1932 may be downstream of the second chamber 122, as shown in Fig. 16. Alternatively, the third chamber 1932 may be upstream of the second chamber 122 (e.g., the third chamber 1932 may be disposed between the first chamber 112 and the second chamber 122, or the first chamber 112 may be disposed between the second chamber 122 and the third chamber 1932). The printer 1934 may be a screen printer or a different kind of printer. The robot arm 150 may be movable along the linear guide 50 to a position inside the third chamber 1932. The robot arm 150 supported by the linear guide 50 may perform a servicing operation of the printer 1934 inside the third chamber 1932.

In other words, according to embodiments described herein, a same robot arm moving along a linear guide may serve multiple printers, such as the printer 124 in the second chamber 122 and the printer 1934 in the third chamber 1932.

For example, the robot arm 150 may pick up one or more items 1150 that are stored in the first chamber 112, for example in response to a signal that a servicing operation is to be performed in the third chamber 1932. The one or more items 1150 may include a consumable for a printer, a replacement part for a printer, a servicing tool, or any combination thereof. The robot arm 150 moving along the linear guide 50 may transport the one or more items from the first chamber 112 to the third chamber 1932. The robot arm 150 may perform a servicing operation of the printer 1934 inside the third chamber 1932 using the one or more items.

In another example, the robot arm 150 may pick up one or more items 1150 that are stored in the first chamber 112, as described above. The robot arm 150 carrying the one or more items may move along the linear guide 50 from the first chamber 112 to the second chamber 122. The robot arm 150 may perform a servicing operation of the printer 124 inside the second chamber 122 using the one or more items 1150. Thereafter, the robot arm 150 carrying the one or more items 1150, or a subset of the one or more items, may move along the linear guide 50 directly from the second chamber 122 to the third chamber 1932, i.e. without passing again via the first chamber 112, or at least without stopping in the first chamber 112. The robot arm 150 may perform a servicing operation of the printer 1934 inside the third chamber 1932 using the one or more items, or using the subset of the one or more items.

Referring again to the example of dispensing printing paste, the one or more items 1150 may include a paste dispenser as described herein. The robot arm 150 may retrieve a paste dispenser in the first chamber 112. The robot arm 150 holding the paste dispenser may move along the linear guide 50 from the first chamber 112 to the second chamber 122. The robot arm 150 may operate the paste dispenser to dispense printing paste to the printer 124 in the second chamber 122. The robot arm 150 holding the paste dispenser may continue directly from the second chamber 122 to the third chamber 1932 along the linear guide 50. The robot arm 150 inside the third chamber 1932 may operate the paste dispenser to dispense printing paste to the printer 1934 in the third chamber 1932. Between dispensing the printing paste in the second chamber 122 and dispensing the printing paste in the third chamber 1932, the robot arm may not pass via the first chamber, or (e.g. in the case that the first chamber 112 is disposed between the second chamber 122 and the third chamber 1932) may pass through the first chamber 112 without stopping in the first chamber 112.

In other embodiments, after dispensing the printing paste to the printer 124 in the second chamber 122, the robot arm 150 may move along the linear guide 50 to return to the first chamber 112. In the first chamber 112, the robot arm 150 may recharge the paste dispenser or pick up a further paste dispenser (e.g. a paste dispenser containing a different kind of printing paste, for example because the printing paste for printing fingers may be different from the printing paste for printing busbars). The robot arm 150 holding the recharged paste dispenser or the further paste dispenser may move along the linear guide 50 from the first chamber 112 to the third chamber 1932. The robot arm 150 inside the third chamber 1932 may operate the recharged paste dispenser or the further paste dispenser to dispense an amount of paste to the printer 1934 inside the third chamber 1932.

The printer 124 in the second chamber 122 may be configured to print a first pattern on a substrate used for the manufacture of a solar cell. For example, the first pattern may be one of a plurality of fingers and a plurality of busbars. The robot arm 150 holding a paste dispenser may be configured to dispense a first amount of printing paste to the printer 124 in the second chamber 122. The printer 1934 in the third chamber 1932 may be configured to print a second pattern on the substrate. For example, the second pattern may be the other one of the plurality of fingers and the plurality of busbars. The robot arm 150 holding a paste dispenser (which may be the same paste dispenser as used for the printer 124 in the second chamber, or a different paste dispenser) may be configured to dispense a second amount of printing paste to the printer 1934 in the third chamber 1932. The second amount may be different than the first amount. By dispensing different amounts of printing paste to the printer 124 and the printer 1934, the periodical replenishment of the printing paste in both printers can be performed by the robot arm 150 at different times. An interference between paste replenishment operations at different printers can be avoided.

The processing line 100 may include additional printing chambers other than the second chamber 122 and the third chamber 1932 (a printing chamber can be understood as a chamber including a printer). For example, the processing line 100 can include four printing chambers, e.g., two printing chambers for printing the busbars and fingers, respectively, on a front side of a substrate used for the manufacture of a solar cell, and two further printing chambers for printing the busbars and fingers, respectively, on a back side of the substrate. The linear guide may extend (at least) between all printing chambers of the processing line. The robot arm, i.e. the same robot arm, can move along the linear guide to each printing chamber to dispense a printing paste to the printer in said chamber. The robot arm can dispense printing paste to several printers without passing via, or without stopping in, the first chamber 112. Alternatively, between paste dispensing operations, the robot arm 150 may travel to the first chamber 112 to recharge the paste dispenser or to pick up a different paste dispenser.

The processing line according to embodiments described herein may include a third station. The third station may include a third chamber and a printer in the third chamber. The linear guide may extend at least between the first chamber, the second chamber and the third chamber. The robot arm may be movable along the linear guide to a position inside the third chamber. The actuator assembly may be configured to move the robot arm along the linear guide to the position inside the third chamber.

The third chamber may be closable, or closed when the robot arm is inside the third chamber.

The robot arm may be configured for performing a servicing operation of the printer in the third chamber. The servicing operation can be a servicing operation as described herein, including for example paste dispensing or screen replacement, or any other servicing operation described herein. The controller may be configured to instruct the robot arm to retrieve one or more items that are stored in the first chamber. The one or more items may include a consumable for a printer, or a replacement part for a printer, or a servicing tool for servicing a printer, or any combination thereof. The controller may be configured to move the robot arm carrying the one or more retrieved items along the linear guide from the first chamber to a position inside the third chamber. The robot arm may be configured for performing a servicing operation of the printer in the third chamber using the one or more retrieved items. The servicing operation may be performed while the printer is operating. The controller may be configured to instruct the robot arm to perform the servicing operation.

The robot arm as described herein may be configured to move from the second chamber (or from the third chamber, or from any other chamber of the processing line) to the first chamber along the linear guide.

For example, the robot arm may be configured to transport a part of the printer 124 from the second chamber to the first chamber, after the part has been removed from the printer 124. The part may be transported from the second chamber to the first chamber for maintenance (e.g. cleaning) or replacement of the part. For example, the robot arm may be configured to transport a pressure application instrument (e.g. a squeegee) of the printer 124 from the second chamber to the first chamber for cleaning the pressure application instrument. The first chamber may include a cleaning apparatus for cleaning the pressure application instrument.

In another example, the robot arm may be configured to transport the substrate from the second chamber to the first chamber, for example for inspection of the substrate. The first chamber may include an inspection apparatus to inspect the substrate. For example, the substrate may be transported from the second chamber to the first chamber after a pattern, e.g. a pattern of fingers and/or busbars, has been printed on the substrate by the printer in the second chamber. The inspection apparatus in the first chamber may be a weighing apparatus, e.g. a scale, for weighing the substrate. The amount of printing material (e.g. printing paste) that was used for printing the pattern can be determined from weighing the substrate.

The first chamber may be arranged on the processing line between the second chamber and the third chamber. The time needed for the robot arm to travel from the first chamber to the second chamber and the third chamber may be optimized by arranging the first chamber between the second chamber and the third chamber.

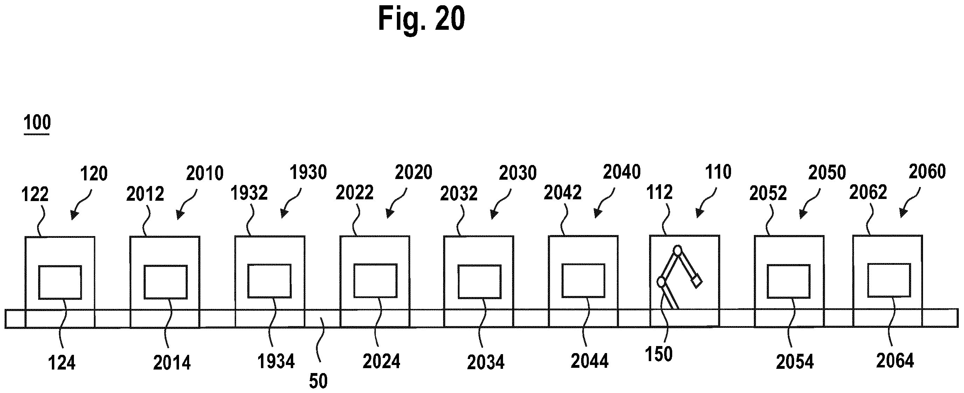

Fig. 20 shows a processing line 100 according to embodiments described herein. The processing line 100 includes a first station 110 and a second station 120 as described herein. The processing line 100 may include a third station 1930 as described herein. The processing line 100 may include any of the following: a station 2010; a station 2020; a station 2030; a station 2040; a station 2050; a station 2060; or any combination thereof. The different stations may be spatially disposed in the manner shown in Fig. 20. That is to say, station 2010 may be downstream of the second station 120; the third station 1930 may be downstream of station 2010; station 2020 may be downstream of the third station 1930; and so on. A substrate used for the manufacture of a solar cell may be subsequently guided through, and processed by, each of the respective stations shown in Fig. 20.

In the second station 120, which is a printing station, the printer 124 in the second chamber 122 may be configured to print a first pattern (e.g. a pattern of fingers) on a back side of the substrate.

Station 2010 may be a curing station. Station 2010 may include a chamber 2012 and a curing apparatus 2014 (e.g. a curing oven) disposed in the chamber 2012. The curing apparatus 2014 may be configured for curing, e.g. drying, the first pattern.

In the third station 1930, which is a printing station, the printer 1934 in the third chamber 1932 may be configured to print a second pattern (e.g. a pattern of busbars) on the back side of the substrate.

Station 2020 may be a curing station. Station 2020 may include a chamber 2022 and a curing apparatus 2024 (e.g. a curing oven) disposed in the chamber 2022. The curing apparatus 2024 may be configured for curing, e.g. drying, the second pattern.

Station 2030 may be a printing station including a chamber 2032 and a printer 2034 in the chamber 2032. The printer 2034 may be configured to print a third pattern (e.g. a pattern of fingers) on the front side of the substrate.

Station 2040 may be a curing station. Station 2040 may include a chamber 2042 and a curing apparatus 2044 (e.g. a curing oven) disposed in the chamber 2042. The curing apparatus 2044 may be configured for curing, e.g. drying, the third pattern.

The first station 110 including the first chamber 112 may be disposed downstream of station 2040. In the first chamber 112, one or more consumables, one or more replacement parts and/or one or more servicing tools may be stored, as described herein. In particular, one or more paste dispensers may be stored in the first chamber 112.

Station 2050 may be disposed downstream of the first station 110. Station 2050 may be a printing station including a chamber 2052 and a printer 2054 in the chamber 2052. The printer 2054 may be configured to print a fourth pattern (e.g. a pattern of busbars) on the front side of the substrate.

Station 2060 may be a curing station. Station 2060 may include a chamber 2062 and a curing apparatus 2064 (e.g. a curing oven) disposed in the chamber 2062. The curing apparatus 2064 may be configured for curing, e.g. drying, the fourth pattern.

The linear guide 50 may extend between all the stations shown in Fig. 20 to allow the robot arm 150 to enter the chambers of all stations. By virtue of the linear guide 50, the robot arm 150 can travel fast and in an unhindered manner to the different chambers along the processing line 100, wherein the robot arm 150 moving along the linear guide 50 may pass through some of the chambers to reach other chambers. The robot arm 150 can travel between the chambers along a direct path, without having to make any detours by going around the chambers. As shown, the first chamber 112 may be disposed between chamber 2042 and chamber 2052, being a beneficial position of the first chamber 112 for reducing the travel time of the robot arm, e.g. when travelling to each of the four printers for dispensing printing paste.

In the example shown in Fig. 20, the linear guide 50 is disposed at a bottom portion, or floor portion, of the chambers. The disclosure shall not be limited thereto. Alternatively, a linear guide disposed at a top portion, e.g. a ceiling, of the chambers can be provided.

According to a further embodiment, a method of operating a processing line for processing a substrate used for the manufacture of a solar cell is provided. The method includes moving a robot arm along a linear guide to a position inside a first chamber of a first station of the processing line. The method includes moving the robot arm along the linear guide to a position inside a second chamber of a second station of the processing line. The second station includes the second chamber and a printer in the second chamber.

The method may include closing the second chamber, the robot arm being inside the closed second chamber.

The method may include operating the printer in the second chamber. Operating the printer may include printing one or more features on the substrate. The method may include performing a servicing operation of the printer by the robot arm while the printer is operated.

The processing line may include a chamber. The chamber may be the first chamber, the second chamber or a further chamber. The method may include moving the robot arm along the linear guide into the chamber at a first side of the chamber. The method may include moving the robot arm along the linear guide from the first side of the chamber to a second side of the chamber to pass through the chamber. The method may include moving the robot arm along the linear guide out of the chamber at the second side of the chamber.

The method may include storing, in the first chamber, any of the following: a consumable for a printer, or a replacement part for a printer, or a servicing tool for servicing a printer, or any combination thereof. The printer may be the printer in the second chamber, the printer in the third chamber, or any other printer.

The method may include transporting, by the robot arm, at least one of the consumable, the replacement part and the servicing tool along the linear guide from the first chamber to the second chamber.

The method may include performing, by the robot arm, a servicing operation of the printer in the second chamber using at least one of the consumable, the replacement part and the servicing tool.

The method may include storing a printing material dispenser in the first chamber. The printing material dispenser may be a paste dispenser for dispensing a printing paste. The method may include transporting the printing material dispenser by the robot arm from the first chamber to the second chamber along the linear guide. The method may include dispensing a printing material to the printer using the printing material dispenser. The printing material may be dispensed by the robot arm operating the printing material dispenser.

The printer in the second chamber may be a screen printer having a screen. The method may include storing a replacement screen for the printer in the first chamber. The method may include transporting the replacement screen by the robot arm from the first chamber to the second chamber along the linear guide. The method may include replacing the screen by the replacement screen in the second chamber. The screen may be replaced by the replacement screen by the robot arm.

The method may include moving the robot arm along the linear guide from the first chamber to the second chamber in response to a signal triggered by a condition of the printer in the second chamber.

The method may include carrying and/or transporting any of the following by the robot arm: a gripper for gripping the substrate, or an inspection system, or an air blower, or an air suction device, or a tool for engaging a fastener, or a gripper for gripping a sheet of paper, or a cleaning brush for removing printing paste, or any combination thereof. At least some of the foregoing items may be stored in the first chamber and retrieved by the robot arm from the first chamber. At least some of the items may be on-board stored tools of the robot arm.

The method may include moving the robot arm along the linear guide to a position inside a third chamber of a third station of the processing line. The third station may include a third chamber and a printer in the third chamber.

The method may include closing the third chamber, the robot arm being inside the closed third chamber.

The method may include operating the printer in the third chamber, including printing one or more features on the substrate. The method may include performing a servicing operation of the printer in the third chamber by the robot arm while the printer is operated.

The method may include transporting, by the robot arm, at least one of a consumable, a replacement part and a servicing tool along the linear guide from the first chamber to the third chamber. The method may include performing, by the robot arm, a servicing operation of the printer in the third chamber using at least one of the consumable, the replacement part and the servicing tool.

The method may include storing a printing material dispenser in the first chamber. The printing material dispenser may be a paste dispenser. The method may include transporting the printing material dispenser by the robot arm from the first chamber to the second chamber along the linear guide. The method may include dispensing a printing material to the printer in the second chamber using the paste dispenser. The printing material dispenser may be operated by the robot arm inside the second chamber to dispense the printing material. The method may include transporting the printing material dispenser by the robot arm from the second chamber to the third chamber along the linear guide. The method may include dispensing a printing material to the printer in the third chamber using the printing material dispenser. The printing material dispenser may be operated by the robot arm inside the third chamber to dispense the printing material.

The method may include storing, in the first chamber, a further replacement screen for the printer in the third chamber. The method may include transporting the further replacement screen by the robot arm from the first chamber to the third chamber along the linear guide. The method may include replacing, by the robot arm, a screen of the printer in the third chamber by the further replacement screen.

The robot arm may be moved along the linear guide from the first chamber to the third chamber in response to a signal triggered by a condition of the printer in the third chamber.

The movements and operations performed by the robot arm as described herein can be performed under the control of the controller of the processing line.

According to a further embodiment, a method of operating a processing line for processing a substrate used for the manufacture of a solar cell is provided. The method includes storing, in a first chamber of a first station of the processing line, any of the following: a consumable for a printer, or a replacement part for a printer, or a servicing tool for servicing a printer, or any combination thereof. The method includes mounting at least one of the consumable, the replacement part and the servicing tool to a robot arm. The method includes moving the robot arm holding the at least one of the consumable, the replacement part and the servicing tool from the first chamber to a second chamber of a second station of the processing line. The printer is disposed in the second chamber. The robot arm is moved along a linear guide extending between the first chamber and the second chamber. The method includes performing, by the robot arm, a servicing operation of the printer using the at least one of the consumable, the replacement part and the servicing tool. The method can include any operations, features or aspects of the method described above.

Embodiments of the above-described methods may be performed by the processing line as described herein. Any operation of a method as described herein may be performed under the control of the controller of the processing line. Further, any operation carried out by the processing line according to embodiments described herein can be performed as part of the methods described above.

While the foregoing is directed to embodiments of the disclosure, other and further embodiments of the disclosure may be devised without departing from the basic scope thereof, and the scope thereof is determined by the claims that follow.

## Claims

1. A processing line (100) for processing a substrate (10) used for the manufacture of a solar cell, comprising:
a first station (110) comprising a first chamber (112);
a second station (120) comprising:
a second chamber (122); and
a printer (124) in the second chamber;
a linear guide (50) extending at least from the first chamber to the second chamber;
a robot arm (150); and
an actuator assembly (160) to move the robot arm along the linear guide, the robot arm being movable along the linear guide to a position inside the first chamber and to a position inside the second chamber,
wherein the first chamber is a storage chamber for storing:
one or more consumables for the printer; or
one or more replacement parts for the printer; or
one or more servicing tools for servicing the printer; or
any combination thereof.

2. The processing line of claim 1, wherein the second chamber is closable when the robot arm is inside the second chamber.

3. The processing line of claim 1 or 2, wherein the processing line comprises a chamber, the chamber being the first chamber, the second chamber or a further chamber,
wherein the robot arm is movable along the linear guide into the chamber at a first side of the chamber, is movable along the linear guide from the first side of the chamber to a second side of the chamber to pass through the chamber, and is movable along the linear guide out of the chamber at the second side of the chamber.

4. The processing line of any of claims 1 to 3, wherein:
(a) the first chamber is configured for storing a printing material dispenser (1400) for dispensing a printing material, wherein the printing material dispenser is mountable to the robot arm, wherein the robot arm holding the printing material dispenser is movable from the first chamber to the second chamber along the linear guide; or
(b) the printer is a screen printer (300) including a screen (350), wherein the first chamber is configured for storing a replacement screen (1610) for the printer, wherein the replacement screen is mountable to the robot arm, wherein the robot arm holding the replacement screen is movable from the first chamber to the second chamber along the linear guide; or
a combination of (a) and (b).

5. The processing line of any of claims 1 to 4, further comprising:
a third station (1930) comprising:
a third chamber (1932); and
a further printer (1934) in the third chamber,
the linear guide extending at least between the first chamber, the second chamber and the third chamber,
the robot arm being movable along the linear guide to a position inside the third chamber.

6. The processing line of any of claims 1 to 5, wherein any of the following is part of, or mountable to, the robot arm:
a gripper for gripping the substrate; or
an inspection system; or
an air blower or an air suction device; or
a tool for engaging a fastener; or
a gripper for gripping a sheet of paper; or
a cleaning brush for removing printing paste; or
any combination thereof.

7. A method of operating a processing line (100) for processing a substrate (10) used for the manufacture of a solar cell, comprising:
moving a robot arm (150) along a linear guide (50) to a position inside a first chamber (112) of a first station (110) of the processing line;
moving the robot arm along the linear guide to a position inside a second chamber (122) of a second station (120) of the processing line, the second station comprising the second chamber and a printer (124) in the second chamber; and
storing, in the first chamber,
a consumable for the printer; or
a replacement part for the printer; or
a servicing tool for servicing the printer; or
any combination thereof.

8. The method of claim 7, further comprising:
closing the second chamber, the robot arm being inside the closed second chamber.

9. The method of claim 7 or 8, further comprising:
operating the printer, including printing one or more features on the substrate; and
performing a servicing operation of the printer by the robot arm while the printer is operated.

10. The method of any of claims 7 to 9, wherein the processing line comprises a chamber, the chamber being the first chamber, the second chamber or a further chamber, the method further comprising:
moving the robot arm along the linear guide into the chamber at a first side of the chamber;
moving the robot arm along the linear guide from the first side of the chamber to a second side of the chamber to pass through the chamber; and
moving the robot arm along the linear guide out of the chamber at the second side of the chamber.

11. The method of any of claims 7 to 10, further comprising:
transporting, by the robot arm, at least one of the consumable, the replacement part and the servicing tool along the linear guide from the first chamber to the second chamber; and/or
performing, by the robot arm, a servicing operation of the printer using at least one of the consumable, the replacement part and the servicing tool.

12. The method of any of claims 7 to 11, wherein:
(a) the method further comprises:
storing a printing material dispenser (1400) in the first chamber;
transporting the printing material dispenser by the robot arm from the first chamber to the second chamber along the linear guide; and
dispensing a printing material to the printer, the printing material being dispensed by the printing material dispenser being operated by the robot arm; or
(b) the printer is a screen printer having a screen, the method further comprising:
storing a replacement screen (1610) for the printer in the first chamber;
transporting the replacement screen by the robot arm from the first chamber to the second chamber along the linear guide; and
replacing the screen by the replacement screen in the second chamber using the robot arm; or
a combination of (a) and (b).

13. The method of any of claims 7 to 12, wherein the robot arm is moved along the linear guide from the first chamber to the second chamber in response to a signal triggered by a condition of the printer in the second chamber.

14. The method of any of claims 7 to 13, further comprising:
moving the robot arm along the linear guide to a position inside a third chamber (1932) of a third station (1930) of the processing line, the third station comprising the third chamber and a further printer (1934) in the third chamber.

15. A method of operating a processing line (100) for processing a substrate (10) used for the manufacture of a solar cell, comprising:
storing, in a first chamber (112) of a first station (110) of the processing line:
a consumable for a printer; or
a replacement part for a printer; or
a servicing tool for servicing a printer; or
any combination thereof;
mounting at least one of the consumable, the replacement part and the servicing tool to a robot arm (150);
moving the robot arm holding the at least one of the consumable, the replacement part and the servicing tool from the first chamber to a second chamber (122) of a second station (120) of the processing line, the printer being disposed in the second chamber, the robot arm being moved along a linear guide (50) extending between the first chamber and the second chamber; and
performing, by the robot arm, a servicing operation of the printer using the at least one of the consumable, the replacement part and the servicing tool.

## Patentansprüche

1. Verarbeitungslinie (100) zur Verarbeitung eines Substrats (10), das für die Herstellung einer Solarzelle verwendet wird, umfassend:
eine erste Station (110), die eine ersten Kammer umfasst (112);
eine zweite Station (120), umfassend:
eine zweite Kammer (122); und
einen Drucker (124) in der zweiten Kammer;
eine Linearführung (50), die sich mindestens von der ersten Kammer zur zweiten Kammer erstreckt;
einen Roboterarm (150); und
eine Aktuatoranordnung (160) zum Bewegen des Roboterarms entlang der Linearführung, wobei der Roboterarm entlang der Linearführung in eine Position innerhalb der ersten Kammer und in eine Position innerhalb der zweiten Kammer bewegbar ist,
wobei die erste Kammer eine Lagerkammer ist, zum Lagern von:
einem oder mehreren Verbrauchsmaterialien für den Drucker; oder
einem oder mehreren Ersatzteilen für den Drucker; oder
einem oder mehreren Wartungswerkzeugen für die Wartung des Druckers; oder
einer beliebigen Kombination davon.

2. Verarbeitungslinie nach Anspruch 1, wobei die zweite Kammer verschließbar ist, wenn sich der Roboterarm in der zweiten Kammer befindet.

3. Verarbeitungslinie nach Anspruch 1 oder 2, wobei die Verarbeitungslinie eine Kammer umfasst, wobei die Kammer die erste Kammer, die zweite Kammer oder eine weitere Kammer ist,
wobei der Roboterarm entlang der Linearführung in die Kammer an einer ersten Seite der Kammer bewegbar ist, entlang der Linearführung von der ersten Seite der Kammer zu einer zweiten Seite der Kammer bewegbar ist, um die Kammer zu durchqueren, und entlang der Linearführung aus der Kammer an der zweiten Seite der Kammer bewegbar ist.

4. Verarbeitungslinie nach einem der Ansprüche 1 bis 3, wobei:
(a) die erste Kammer zur Aufnahme eines Druckmaterialspenders (1400) zur Ausgabe eines Druckmaterials konfiguriert ist, wobei der Druckmaterialspender an dem Roboterarm montierbar ist, wobei der Roboterarm, der den Druckmaterialspender hält, von der ersten Kammer zu der zweiten Kammer entlang der Linearführung bewegbar ist; oder
(b) der Drucker ein Siebdrucker (300), der ein Sieb (350) aufweist, ist, wobei die erste Kammer zum Aufbewahren eines Austauschsiebs (1610) für den Drucker konfiguriert ist, wobei das Austauschsieb an dem Roboterarm montierbar ist, wobei der Roboterarm, der das Austauschsieb hält, von der ersten Kammer zu der zweiten Kammer entlang der Linearführung bewegbar ist; oder
eine Kombination aus (a) und (b).

5. Verarbeitungslinie nach einem der Ansprüche 1 bis 4, ferner umfassend:
eine dritte Station (1930) umfassend:
eine dritte Kammer (1932); und
einen weiteren Drucker (1934) in der dritten Kammer,
wobei sich die Linearführung zumindest zwischen der ersten Kammer, der zweiten Kammer und der dritten Kammer erstreckt,
wobei der Roboterarm entlang der Linearführung in eine Position innerhalb der dritten Kammer bewegt werden kann.

6. Verarbeitungslinie nach einem der Ansprüche 1 bis 5, wobei eines der folgenden Elemente Teil des Roboterarms ist oder daran befestigt werden kann:
ein Greifer zum Greifen des Substrats; oder
ein Inspektionssystem; oder
ein Luftgebläse oder eine Luftansaugvorrichtung; oder
ein Werkzeug zum Einsetzten eines Befestigungselements; oder
ein Greifer zum Greifen eines Blattes Papier; oder
eine Reinigungsbürste zum Entfernen von Druckpaste; oder
eine beliebige Kombination davon.

7. Verfahren zum Betreiben einer Verarbeitungslinie (100) zur Verarbeitung eines Substrats (10), das für die Herstellung einer Solarzelle verwendet wird, umfassend:
Bewegen eines Roboterarms (150) entlang einer Linearführung (50) in eine Position innerhalb einer ersten Kammer (112) einer ersten Station (110) der Verarbeitungslinie;
Bewegen des Roboterarms entlang der Linearführung in eine Position innerhalb einer zweiten Kammer (122) einer zweiten Station (120) der Verarbeitungslinie, wobei die zweite Station die zweite Kammer und einen Drucker (124) in der zweiten Kammer umfasst; und
Lagern in der ersten Kammer,
eines Verbrauchsmaterials für den Drucker; oder
eines Ersatzteils für den Drucker; oder
eines Wartungswerkzeug für die Wartung des Druckers; oder
einer beliebigen Kombination davon.

8. Verfahren nach Anspruch 7, ferner umfassend:
Verschließen der zweiten Kammer, wobei sich der Roboterarm innerhalb der geschlossenen zweiten Kammer befindet.

9. Verfahren nach Anspruch 7 oder 8, ferner umfassend:
Betreiben des Druckers, einschließlich des Druckens eines oder mehrerer Merkmale auf das Substrat; und
Durchführen eines Wartungsvorgangs des Druckers durch den Roboterarm, während der Drucker betrieben wird.

10. Verfahren nach einem der Ansprüche 7 bis 9, wobei die Verarbeitungslinie eine Kammer umfasst, bei der es sich um die erste Kammer, die zweite Kammer oder eine weitere Kammer handelt, wobei das Verfahren ferner umfasst:
Bewegen des Roboterarms entlang der Linearführung in die Kammer an einer ersten Seite der Kammer;
Bewegen des Roboterarms entlang der Linearführung von der ersten Seite der Kammer zu einer zweiten Seite der Kammer, um die Kammer zu durchqueren; und
Bewegen des Roboterarms entlang der Linearführung aus der Kammer an der zweiten Seite der Kammer heraus.

11. Verfahren nach einem der Ansprüche 7 bis 10, ferner umfassend:
Transportieren des Verbrauchsmaterials, des Ersatzteils und/oder des Wartungswerkzeugs durch den Roboterarm entlang der Linearführung von der ersten Kammer zur zweiten Kammer; und/oder
Durchführen eines Wartungsvorgangs des Druckers durch den Roboterarm unter Verwendung des Verbrauchsmaterials, des Ersatzteils und/oder des Wartungswerkzeugs.

12. Verfahren nach einem der Ansprüche 7 bis 11, wobei:
(a) das Verfahren ferner umfasst:
Lagern eines Druckmaterialspenders (1400) in der ersten Kammer;
Transportieren des Druckmaterialspenders durch den Roboterarm von der ersten Kammer zur zweiten Kammer entlang der Linearführung; und
Ausgeben eines Druckmaterials an den Drucker, wobei das Druckmaterial durch den Druckmaterialspender ausgegeben wird, der durch den Roboterarm betrieben wird; oder
(b) der Drucker ein Siebdrucker mit einem Sieb ist, wobei das Verfahren ferner umfasst:
Lagern eines Ersatzsiebs (1610) für den Drucker in der ersten Kammer;
Transportieren des Ersatzsiebes durch den Roboterarm von der ersten Kammer zur zweiten Kammer entlang der Linearführung; und
Ersetzen des Siebes durch das Ersatzsieb in der zweiten Kammer unter Verwendung des Roboterarms; oder
eine Kombination aus (a) und (b).

13. Verfahren nach einem der Ansprüche 7 bis 12, wobei der Roboterarm als Reaktion auf ein Signal, das durch einen Zustand des Druckers in der zweiten Kammer ausgelöst wird, entlang der Linearführung von der ersten Kammer zur zweiten Kammer bewegt wird.

14. Verfahren nach einem der Ansprüche 7 bis 13, ferner umfassend:
Bewegen des Roboterarms entlang der Linearführung in eine Position innerhalb einer dritten Kammer (1932) einer dritten Station (1930) der Verarbeitungslinie, wobei die dritte Station die dritte Kammer und einen weiteren Drucker (1934) in der dritten Kammer umfasst.

15. Verfahren zum Betreiben einer Verarbeitungslinie (100) zur Verarbeitung eines Substrats (10), das für die Herstellung einer Solarzelle verwendet wird, umfassend:
Lagern in einer ersten Kammer (112) einer ersten Station (110) der Verarbeitungslinie:
eines Verbrauchsmaterials für einen Drucker; oder
eines Ersatzteils für einen Drucker; oder
eines Wartungswerkzeugs für die Wartung eines Druckers; oder
einer beliebigen Kombination davon;
Anbringen des Verbrauchsmaterials, des Ersatzteils und/oder des Wartungswerkzeugs an einen Roboterarm (150);
Bewegen des Roboterarms, der das Verbrauchsmaterial, das Ersatzteil und/oder das Wartungswerkzeug hält, von der ersten Kammer zu einer zweiten Kammer (122) einer zweiten Station (120) der Verarbeitungslinie, wobei der Drucker in der zweiten Kammer angeordnet ist und der Roboterarm entlang einer Linearführung (50) bewegt wird, die sich zwischen der ersten Kammer und der zweiten Kammer erstreckt; und
Durchführen eines Wartungsvorgangs des Druckers durch den Roboterarm unter Verwendung des Verbrauchsmaterials, des Ersatzteils und/oder des Wartungswerkzeugs.

## Revendications

1. Ligne de traitement (100) destinée à traiter un substrat (10) utilisé pour la fabrication d'une cellule solaire, comprenant :
une première station (110) comprenant une première chambre (112) ;
une deuxième station (120) comprenant :
une deuxième chambre (122) ; et
une imprimante (124) dans la deuxième chambre ;
un guide linéaire (50) s'étendant au moins de la première chambre vers la deuxième chambre ;
un bras robotique (150) ; et
un ensemble actionneur (160) pour déplacer le bras robotique le long du guide linéaire, le bras robotique étant mobile le long du guide linéaire vers une position à l'intérieur de la première chambre et vers une position à l'intérieur de la deuxième chambre,
dans laquelle la première chambre est une chambre de stockage pour stocker :
un ou plusieurs consommables pour l'imprimante ; ou
une ou plusieurs pièces de remplacement pour l'imprimante ; ou
un ou plusieurs outils d'entretien pour l'entretien de l'imprimante ; ou
leur combinaison quelconque.

2. Ligne de traitement selon la revendication 1, dans laquelle la deuxième chambre peut être fermée lorsque le bras robotique se trouve à l'intérieur de la deuxième chambre.

3. Ligne de traitement selon la revendication 1 ou 2, dans laquelle la ligne de traitement comprend une chambre, la chambre étant la première chambre, la deuxième chambre ou une chambre supplémentaire,
dans laquelle le bras robotique est mobile le long du guide linéaire dans la chambre au niveau d'un premier côté de la chambre, est mobile le long du guide linéaire du premier côté de la chambre vers un second côté de la chambre pour traverser la chambre, et est mobile le long du guide linéaire pour sortir de la chambre au niveau du second côté de la chambre.

4. Ligne de traitement selon l'une quelconque des revendications 1 à 3, dans laquelle :
(a) la première chambre est conçue pour stocker un distributeur de matériel d'impression (1400) pour distribuer un matériel d'impression, dans laquelle le distributeur de matériel d'impression peut être monté sur le bras robotique, dans laquelle le bras robotique tenant le distributeur de matériel d'impression est mobile de la première chambre vers la seconde chambre le long du guide linéaire ; ou
(b) l'imprimante est une machine de sérigraphie (300) comportant un écran (350), dans laquelle la première chambre est conçue pour stocker un écran de remplacement (1610) pour l'imprimante, dans laquelle l'écran de remplacement peut être monté sur le bras robotique, dans laquelle le bras robotique tenant l'écran de remplacement est mobile de la première chambre vers la seconde chambre le long du guide linéaire ; ou
une combinaison de (a) et (b).

5. Ligne de traitement selon l'une quelconque des revendications 1 à 4, comprenant en outre :
une troisième station (1930) comprenant :
une troisième chambre (1932) ; et
une imprimante supplémentaire (1934) dans la troisième chambre,
le guide linéaire s'étend au moins entre la première chambre, la deuxième chambre et la troisième chambre,
le bras robotique étant mobile le long du guide linéaire vers une position à l'intérieur de la troisième chambre.

6. Ligne de traitement selon l'une quelconque des revendications 1 à 5, dans laquelle l'un quelconque des éléments suivants fait partie du bras robotique ou peut être monté sur celui-ci :
un dispositif de préhension pour prendre le substrat ; ou
un système d'inspection ; ou
une soufflerie ou un dispositif d'aspiration d'air ; ou
un outil de mise en prise d'une attache ; ou
un dispositif de préhension pour prendre une feuille de papier ; ou
une brosse de nettoyage pour enlever la pâte d'impression ; ou
leur combinaison quelconque.

7. Procédé de fonctionnement d'une ligne de traitement (100) destinée à traiter un substrat (10) utilisé pour la fabrication d'une cellule solaire, comprenant :
le déplacement d'un bras robotique (150) le long d'un guide linéaire (50) vers une position à l'intérieur d'une première chambre (112) d'une première station (110) de la chaîne de traitement ;
le déplacement du bras robotique le long du guide linéaire jusqu'à une position à l'intérieur d'une deuxième chambre (122) d'une deuxième station (120) de la ligne de traitement, la deuxième station comprenant la deuxième chambre et une imprimante (124) dans la deuxième chambre ; et
le stockage, dans la première chambre,
d'un consommable pour l'imprimante ; ou
d'une pièce de remplacement pour l'imprimante ; ou
d'un outil d'entretien pour l'entretien de l'imprimante ; ou
de leur combinaison quelconque.

8. Procédé selon la revendication 7, comprenant en outre :
la fermeture de la deuxième chambre, le bras robotique se trouvant à l'intérieur de la deuxième chambre fermée.

9. Procédé selon la revendication 7 ou 8, comprenant en outre :
le fonctionnement de l'imprimante, y compris l'impression d'une ou plusieurs caractéristiques sur le substrat ; et
la réalisation d'une opération d'entretien de l'imprimante par le bras robotique pendant que l'imprimante fonctionne.

10. Procédé selon l'une quelconque des revendications 7 à 9, dans lequel la ligne de traitement comprend une chambre, la chambre étant la première chambre, la deuxième chambre ou une chambre supplémentaire, le procédé comprenant en outre :
le déplacement du bras robotique le long du guide linéaire dans la chambre au niveau d'un premier côté de la chambre ;
le déplacement du bras robotique le long du guide linéaire du premier côté de la chambre vers un second côté de la chambre pour traverser la chambre ; et
le déplacement du bras robotique le long du guide linéaire hors de la chambre au niveau du second côté de la chambre.

11. Procédé selon l'une quelconque des revendications 7 à 10, comprenant en outre :
le transport, par le bras robotique, d'au moins l'un parmi le consommable, la pièce de remplacement et l'outil d'entretien le long du guide linéaire, de la première chambre vers la seconde chambre ; et/ou
la réalisation, par le bras robotique, d'une opération d'entretien de l'imprimante à l'aide d'au moins l'un parmi le consommable, la pièce de remplacement et l'outil de maintenance.

12. Procédé selon l'une quelconque des revendications 7 à 11, dans lequel :
(a) le procédé comprend en outre :
le stockage d'un distributeur de matériel d'impression (1400) dans la première chambre ;
le transport du distributeur de matériel d'impression par le bras robotique de la première chambre vers la seconde chambre le long du guide linéaire ; et
la distribution d'un matériel d'impression à l'imprimante, le matériel d'impression étant distribué par le distributeur de matériel d'impression mis en fonctionnement par le bras robotique ; ou
(b) l'imprimante est une machine de sérigraphie dotée d'un écran, le procédé comprenant en outre :
le stockage d'un écran de remplacement (1610) pour l'imprimante dans la première chambre ;
le transport de l'écran de remplacement par le bras robotique de la première chambre vers la seconde chambre le long du guide linéaire ; et
le remplacement de l'écran par l'écran de remplacement dans la deuxième chambre à l'aide du bras robotique ; ou
une combinaison de (a) et (b).

13. Procédé selon l'une quelconque des revendications 7 à 12, dans lequel le bras robotique est déplacé le long du guide linéaire de la première chambre vers la seconde chambre en réponse à un signal déclenché par une condition de l'imprimante dans la deuxième chambre.

14. Procédé selon l'une quelconque des revendications 7 à 13, comprenant en outre :
le déplacement du bras robotique le long du guide linéaire vers une position à l'intérieur d'une troisième chambre (1932) d'une troisième station (1930) de la ligne de traitement, la troisième station comprenant la troisième chambre et une imprimante supplémentaire (1934) dans la troisième chambre.

15. Procédé de fonctionnement d'une ligne de traitement (100) destinée à traiter un substrat (10) utilisé pour la fabrication d'une cellule solaire, comprenant :
le stockage, dans une première chambre (112) d'une première station (110) de la ligne de traitement :
d'un consommable pour une imprimante ; ou
d'une pièce de remplacement pour une imprimante ; ou
d'un outil d'entretien pour l'entretien d'une imprimante ; ou
de leur combinaison quelconque ;
le montage d'au moins l'un parmi le consommable, la pièce de remplacement et l'outil d'entretien sur un bras robotique (150) ;
le déplacement du bras robotique tenant l'au moins un parmi le consommable, la pièce de remplacement et l'outil d'entretien de la première chambre vers une deuxième chambre (122) d'une deuxième station (120) de la ligne de traitement, l'imprimante étant disposée dans la deuxième chambre, le bras robotique étant déplacé le long d'un guide linéaire (50) s'étendant entre la première chambre et la deuxième chambre ; et
la réalisation, par le bras robotique, d'une opération d'entretien de l'imprimante à l'aide de l'au moins un parmi le consommable, la pièce de remplacement et l'outil d'entretien.
